(19) Europäisches Patentamt
European Patent Office
Office européen des brevets

(11) EP 2 594 571 A1

(12) **EUROPÄISCHE PATENTANMELDUNG**

(43) Veröffentlichungstag:
**22.05.2013 Patentblatt 2013/21**

(51) Int Cl.:
***C07F 1/08*** *(2006.01)* ***H01L 51/00*** *(2006.01)*

(21) Anmeldenummer: **11195010.1**

(22) Anmeldetag: **21.12.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **16.11.2011 EP 11189397**

(71) Anmelder: **Cynora GmbH**
**76344 Eggenstein-Leopoldshafen (DE)**

(72) Erfinder: **Die Erfindernennung liegt noch nicht vor**

(74) Vertreter: **Hoppe, Georg Johannes**
**darani Anwaltskanzlei**
**Beuckestrasse 20**
**14163 Berlin (DE)**

# (54) Kupfer-Komplexe für optoelektronische Anwendungen

(57) Die Erfindung betrifft Kupfer(I)komplexe der Formel

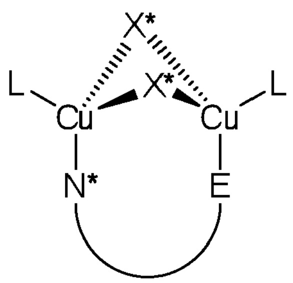

**Formel A**

mit

X* = Cl, Br, I, CN, OCN, SCN, Alkinyl und/oder $N_3$ (unabhängig voneinander),
N*∩E = ein zweibindiger Ligand mit
E = Phosphanyl/Arsenyl/Antimonyl-Rest der Form $R_2E$ (mit R = Alkyl, Aryl, Alkoxyl, Phenoxyl, oder Amid);
N* = Imin-Funktion, die Bestandteil einer aromatische Gruppe ist, die ausgewählt ist aus Pyridyl, Pyrimidyl, Pyridazinyl, Triazinyl, Oxazolyl, Thiazolyl, Imidazolyl, Pyrazol, Isoxazol, Isothiazol, 1,2,4-Triazole, 1,2,4-Oxadiazole, 1,2,4-Thiadiazole, Tetrazole, 1,2,3,4-Oxatriazole und/oder 1,2,3,4-Thiatriazole, etc.,
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet,
L = entweder ein einzähniger Liganden $DR_3$ mit
D = Phosphanyl/Arsenyl/Antimonyl-Rest der Form $R_3D$ (mit R = Alkyl, Aryl, Alkoxyl, Phenoxyl, oder Amid), oder ein zweizähniger Liganden $R_2D$-B-$DR_2$ mit
D = Phosphanyl/Arsenyl/Antimonyl-Rest der Form $R_2D$ (mit R = Alkyl, Aryl, Alkoxyl, Phenoxyl, oder Amid), der über eine Brücke B mit einem weiteren Rest D verbunden ist, wobei die Brücke B eine Alkylen- oder Arylen-Gruppe oder eine Kombination beider, oder -O-, -NR- oder -$SiR_2$- ist,
sowie ihre Verwendung in optoelektronischen Bauelementen, insbesondere in OLEDs.

EP 2 594 571 A1

## Beschreibung

Die Erfindung betrifft Kupfer(I)komplexe der allgemeinen Formel A, insbesondere zur Verwendung in optoelektronischen Bauelementen.

## Einleitung

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren $m^2$ Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLED**s, den **O**rganic Light **E**mitting **D**iodes, die in Figur 1 schematisch und vereinfacht dargestellt ist.

Derartige Bauteile bestehen vorwiegend aus organischen Schichten, wie in Fig. 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden.[i-vi] Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt.[i-v] Für Triplett-Emitter wurden bereits viele Schutzrechte beantragt bzw. erteilt. [vii-xix]

Kupferkomplexe der Form $Cu_2X_2L_4$, $Cu_2X_2L'_2$ und $Cu_2X_2L_2L'$ (L = Phosphan-, Amin-, Imin-Ligand; L' = zweizähniger Phosphan-, Imin-, Amin-Ligand, s.u.) sind bereits aus dem Stand der Technik bekannt. Sie zeigen intensive Lumineszenz bei Anregung mit UV Licht. Die Lumineszenz kann entweder von einem MLCT-, CC (*cluster centered*)- oder XLCT (*halogen-to-ligand-charge-transfer*)-Zustand oder einer Kombination dieser stammen. Weitere Einzelheiten zu ähnlichen Cu(I)-Systemen können der Literatur entnommen werden.[xx] Bei dem verwandten $[Cu_2X_2(PPh_3)_2nap]$-Komplex (nap = 1,8-Naphthyridin, X = Br, I) wird ein Übergang zwischen dem Molekülorbital der $\{Cu_2X_2\}$-Einheit (Cu d und Halogen p-Orbitale) und den $\pi^*$-Orbitalen der nap-Gruppe diskutiert. [xxi]

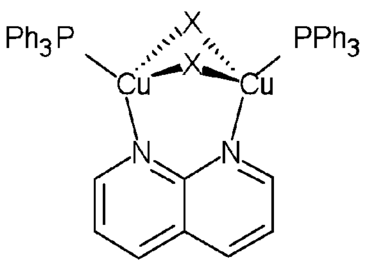

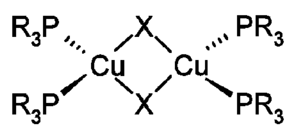

Beispiel einer Struktur der Komplexe der Form Beispiele der Komplexe der Form $Cu_2X_2L_4$ (L = $Cu_2X_2L_2L'$ (L = $PPh_3$, L' = 1,8-Naphthyridin, X $PR_3$, X = Cl, Br, oder I) = Br, I)

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:

- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Vor diesem Hintergrund lag der vorliegenden Erfindung die Aufgabe zu Grunde, zumindest einige der oben genannten Nachteile zu überwinden.

Das der Erfindung zu Grunde liegende Problem wird durch die Bereitstellung von heteroleptischen zweikernigen Kupfer(I)komplexen der Form $Cu_2X_2(E\cap N^*)L_2$ gelöst, die eine Struktur gemäß Formel A aufweisen oder von einer Struktur nach Formel A sind:

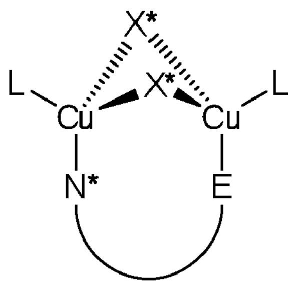

**Formel A**

In Formel A (nachfolgend auch als $Cu_2X_2(E\cap N^*)L_2$ bezeichnet) steht $E\cap N^*$ für einen chelatisierenden N-heterozyklischen Liganden, der über ein Stickstoffatom und entweder ein Phosphor-, Arsen- oder Antimonatom an den $Cu_2X_2$-Kern bindet, und L unabhängig voneinander für einen Phosphan-, Arsan- oder Antimon-Liganden, wobei beide Liganden L auch miteinander verbunden sein können, so dass sich ein zweibindiger Ligand ergibt, oder wobei ein Ligand L bzw. beide Liganden L auch mit $E\cap N^*$ verbunden sein können, so dass sich ein dreibindiger oder vierbindiger Ligand ergibt. L ist ungleich zu $E\cap N^*$.

Spezielle Ausführungsformen der erfindungsgemäßen zweikernigen Kupfer(I)komplexe der Formel A werden durch die Verbindung der Formeln I und II dargestellt und im Folgenden erläutert.

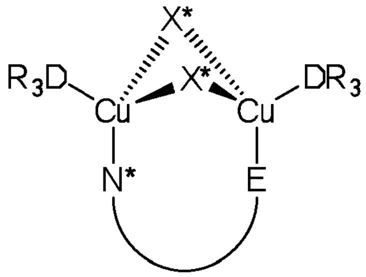

**Formel I**

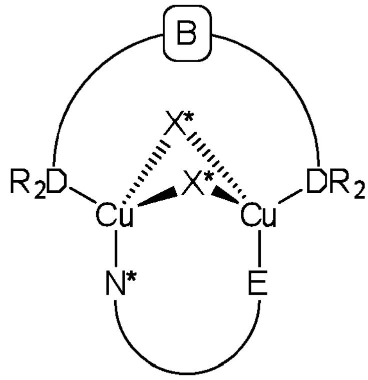

**Formel II**

X* = Cl, Br, I, CN, OCN, SCN, Alkinyl und/oder $N_3$ (also unabhängig voneinander, so dass der Komplex zwei gleiche oder zwei unterschiedliche Atome X* aufweisen kann),

N*∩E = zweibindige Liganden mit E = Phosphanyl/Arsenyl/Antimonyl-Rest der Form $R_2E$ (R = Alkyl, Aryl, Alkoxyl, Phenoxyl, Amid); N* = Imin-Funktion. Bei "∩" handelt es sich um ein Kohlenstoffatom. Insbesondere handelt es sich bei E um eine $Ph_2P$-Gruppe (Ph = Phenyl), die Imin-Funktion ist Bestandteil einer aromatische Gruppe (z. B. Pyridyl, Pyrimidyl, Pyridazinyl, Triazinyl, Oxazolyl, Thiazolyl, Imidazolyl, Pyrazol, Isoxazol, Isothiazol, 1,2,4-Triazole, 1,2,4-Oxadiazole, 1,2,4-Thiadiazole, Tetrazole, 1,2,3,4-Oxatriazole und/oder 1,2,3,4-Thiatriazole, etc.). "∩" ist ebenfalls Bestandteil dieser aromatischen Gruppe. Das Kohlenstoffatom befindet sich sowohl direkt benachbart zum Imin-Stickstoff-Atom als auch zum E-Atom.

D = P und/oder As und/oder Sb.

R = jeweils unabhängig voneinander Wasserstoff, Halogen sein oder Substituenten, die über Sauerstoff- (-OR), Stickstoff- (-$NR_2$) oder Siliziumatome (-$SiR_3$) gebunden sind sowie Alkyl- (auch verzweigt oder zyklisch), Aryl-, Heteroaryl-, Alkenyl-, Alkinyl-Gruppen bzw. substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und $CF_3$-Gruppen. Die Reste R können optional auch zu annelierten Ringsystemen führen.

N*∩E und/oder L kann optional substituiert sein, insbesondere mit funktionellen Gruppen, die den Ladungsträgertransport verbessern und/oder Gruppen, die die Löslichkeit des Kupfer(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Ein erfindungsgemäßer Kupfer(I)komplex besteht bevorzugt aus einem zweibindigen Liganden N*∩E und entweder zwei identischen einzähnigen Liganden $DR_3$ oder einem zweizähnigen Liganden $R_2D$-B-$DR_2$, wodurch unterschiedliche Funktionalitäten über die Peripherie der verschiedenen Liganden eingeführt werden können (beispielsweise je eine Lochtransport- und Elektrontransport-Einheit, im Folgenden als Loch- bzw. Elektronenleiter bezeichnet) und somit ein optimaler Ladungsträgertransport zu und eine wohldefinierte Rekombination direkt auf dem Kupferkomplex gewährleistet wird. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Kupfer(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden N*∩E um folgende Liganden:

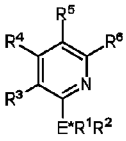 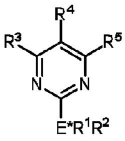 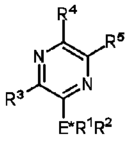 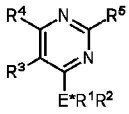 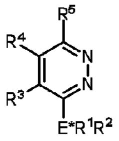 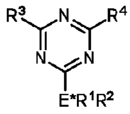

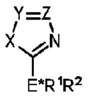

X = NR$^3$, Y = CR$^4$, Z = CR$^5$: 2E*R$^1$R$^2$-1R$^3$-4R$^5$-5R$^4$-1H-Imidazol
X = NR$^3$, Y = N, Z = CR$^4$: 5E*R$^1$R$^2$-1R$^3$-3R$^4$-1H-1,2,4-Triazol
X = NR$^3$, Y = CR$^4$, Z = N: 3E*R$^1$R$^2$-4R$^3$-5R$^4$-4H-1,2,4-Triazol
X = NR$^3$, Y = N, Z = N: 5E*R$^1$R$^2$-1R$^3$-1H-Tetrazol
X = O, Y = CR$^3$, Z = CR$^4$: 2E*R$^1$R$^2$-4R$^4$-5R$^3$-Oxazol
X = O, Y = N, Z = CR$^3$: 5E*R$^1$R$^2$-3R$^3$-1,2,4-Oxadiazol
X = O, Y = CR$^3$, Z = N: 2E*R$^1$R$^2$-5R$^3$-1,3,4-Oxadiazol
X = O, Y = N, Z = N: 5E*R$^1$R$^2$-1,2,3,4-Oxatriazol
X = S, Y = CR$^3$, Z = CR$^4$: 2E*R$^1$R$^2$-4R$^4$-5R$^3$-Thiazol
X = S, Y = N, Z = CR$^3$: 5E*R$^1$R$^2$-3R$^3$-1,2,4-Thiadiazol
X = S, Y = CR$^3$, Z = N: 2E*R$^1$R$^2$-5R$^3$-1,3,4-Thiadiazol
X = S, Y = N, Z = N: 5E*R$^1$R$^2$-1,2,3,4-Thiatriazol

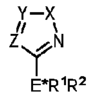

X = NR$^3$, Y = CR$^4$, Z = CR$^5$: 3E*R$^1$R$^2$-1R$^3$-4R$^5$-5R$^4$-1H-Pyrazol
X = NR$^3$, Y = N, Z = CR$^4$: 4E*R$^1$R$^2$-2R$^3$-5R$^4$-2H-1,2,3-Triazol
X = NR$^3$, Y = CR$^4$, Z = N: 3E*R$^1$R$^2$-1R$^3$-5R$^4$-1H-1,2,4-Triazol
X = NR$^3$, Y = N, Z = N: 5E*R$^1$R$^2$-2R$^3$-2H-Tetrazol
X = O, Y = CR$^3$, Z = CR$^4$: 3E*R$^1$R$^2$-4R$^4$-5R$^3$-Isoxazol
X = O, Y = N, Z = CR$^3$: 3E*R$^1$R$^2$-4R$^3$-1,2,5-Oxadiazol
X = O, Y = CR$^3$, Z = N: 3E*R$^1$R$^2$-5R$^3$-1,2,4-Oxadiazol
X = O, Y = N, Z = N: 4E*R$^1$R$^2$-1,2,3,5-Oxatriazol
X = S, Y = CR$^3$, Z = CR$^4$: 3E*R$^1$R$^2$-4R$^4$-5R$^3$-Isothiazol
X = S, Y = N, Z = CR$^3$: 3E*R$^1$R$^2$-4R$^3$-1,2,5-Thiadiazol
X = S, Y = CR$^3$, Z = N: 3E*R$^1$R$^2$-5R$^3$-1,2,4-Thiadiazol
X = S, Y = N, Z = N: 4E*R$^1$R$^2$-1,2,3,5-Thiatriazol

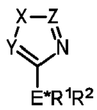

X = NR$^3$, Y = CR$^4$, Z = CR$^5$: 4E*R$^1$R$^2$-1R$^3$-2R$^5$-5R$^4$-1H-Imidazol
X = NR$^3$, Y = N, Z = CR$^4$: 3E*R$^1$R$^2$-1R$^3$-5R$^4$-1H-1,2,4-Triazol
X = NR$^3$, Y = CR$^4$, Z = N: 4E*R$^1$R$^2$-1R$^3$-5R$^4$-1H-1,2,3-Triazol
X = NR$^3$, Y = N, Z = N: 5E*R$^1$R$^2$-2R$^3$-2H-Tetrazol
X = O, Y = CR$^3$, Z = CR$^4$: 4E*R$^1$R$^2$-2R$^4$-5R$^3$-Oxazol
X = O, Y = N, Z = CR$^3$: 3E*R$^1$R$^2$-5R$^3$-1,2,4-Oxadiazol
X = O, Y = CR$^3$, Z = N: 4E*R$^1$R$^2$-5R$^3$-1,2,3-Oxadiazol
X = O, Y = N, Z = N: 4E*R$^1$R$^2$-1,2,3,5-Oxatriazol
X = S, Y = CR$^3$, Z = CR$^4$: 4E*R$^1$R$^2$-2R$^4$-5R$^3$-Thiazol
X = S, Y = N, Z = CR$^3$: 3E*R$^1$R$^2$-5R$^3$-1,2,4-Thiadiazol
X = S, Y = CR$^3$, Z = N: 4E*R$^1$R$^2$-5R$^3$-1,2,3-Thiadiazol
X = S, Y = N, Z = N: 4E*R$^1$R$^2$-1,2,3,5-Thiatriazol

mit
E* = P, As oder Sb,
X = NR$^3$, O oder S,
Y = CR$^3$, CR$^4$ oder N,
Z = CR$^4$, CR$^5$ oder N,
R$^1$-R$^5$ können jeweils unabhängig voneinander Wasserstoff, Halogen sein oder Substituenten, die über Sauerstoff- (-OR), Stickstoff- (-$NR_2$) oder Siliziumatome (-$SiR_3$) gebunden sind sowie Alkyl-(auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und $CF_3$-Gruppen. R3-R5 können optional auch zu annelierten Ringsystemen führen.

Bevorzugt handelt es sich bei dem Liganden $DR_3$ (s. Formel I) um folgende Liganden:

einzähnige Liganden mit

D = P, As oder Sb,

$R_3$ können jeweils unabhängig voneinander Wasserstoff, Halogen sein oder Substituenten, die über Sauerstoff- (-OR), Stickstoff- ($-NR_2$) oder Siliziumatome ($-SiR_3$) gebunden sind sowie Alkyl- (auch verzweigt oder zyklisch), Aryl-, Heteroaryl-, Alkenyl-, Alkinyl-Gruppen bzw. substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und $CF_3$-Gruppen. Die drei einzelnen Reste R können optional auch zu annelierten Ringsystemen führen.

Bevorzugt handelt es sich bei dem Liganden $R_2D$-B-$DR_2$ (s. Formel II) um folgende Liganden: zweizähnige Liganden mit

D = P, As oder Sb,

$R_2$ können jeweils unabhängig voneinander Wasserstoff, Halogen sein oder Substituenten, die über Sauerstoff- (-OR), Stickstoff- ($-NR_2$) oder Siliziumatome ($-SiR_3$) gebunden sind sowie Alkyl- (auch verzweigt oder zyklisch), Aryl-, Heteroaryl-, Alkenyl-, Alkinyl-Gruppen bzw. substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und $CF_3$-Gruppen, die über eine Brücke B mit einem weiteren Rest D verbunden ist und damit einen zweizähnigen Liganden bildet, wobei die Brücke B eine Alkylen- oder Arylen-Gruppe oder eine Kombination beider, oder -O-, -NR- oder $-SiR_2$- ist. Die Reste $R_2$ können auch zu anellierten Ringsystemen führen.

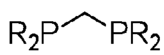 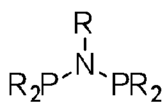 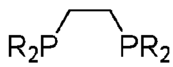 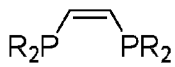 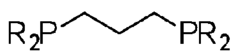

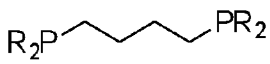 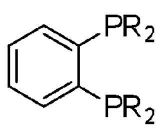 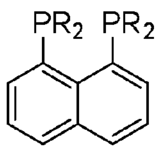 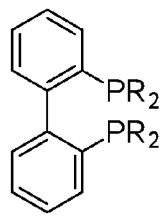 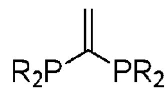

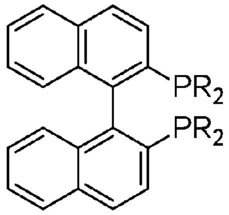 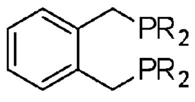 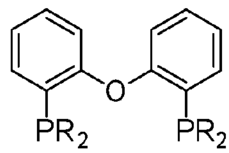 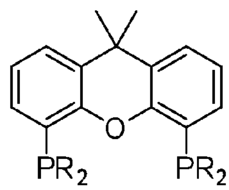

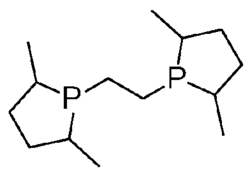 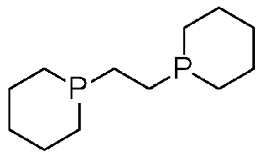 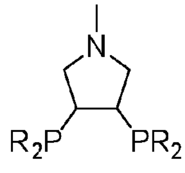 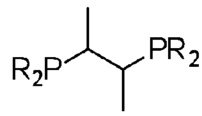

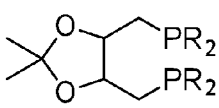 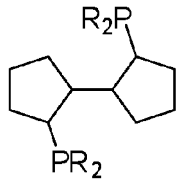 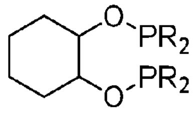 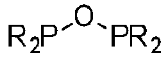 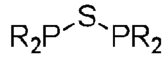

Sowohl der zweibindige Ligand N*∩E als auch die zwei einzähnigen Liganden $DR_3$ oder der zweizähnige Ligand $R_2D$-B-$DR_2$ können an geeigneten Stellen mit mindestens einer Funktions-Gruppe FG substituiert sein. So können sich direkte $C_{FG}$-$C_{N^*\cap E}$ Bindungen bilden, wobei $C_{N^*\cap E}$ ein C-Atom des N*∩E Liganden darstellt und $C_{FG}$ ein C-Atom der Funktions-Gruppe. Ist das anbindende Atom ein Stickstoffatom, so ergeben sich $N_{FG}$-$C_{N^*\cap E}$ Bindungen,

wobei $N_{FG}$ für das Stickstoffatom steht. Andererseits kann die Funktions-Gruppe über eine Brücke an den N*∩E Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: $C_{FG}$-O-$C_{N^*\cap E}$, $C_{FG}$-S-$C_{N^*\cap E}$, $C_{FG}$-C(O)-O-$C_{N^*\cap E}$, $C_{FG}$-C(O)-NH-$C_{N^*\cap E}$, $C_{FG}$-$CH_2$-$C_{N^*\cap E}$, $C_{FG}$-SiR'$_2$-$C_{N^*\cap E}$, $C_{FG}$-CH=CH-$C_{N^*\cap}$E, $C_{FG}$-C≡C-$C_{N^*\cap E}$, $N_{FG}$-$CH_2$-$CN_{*\cap E}$.

Die Verfahren zur Verknüpfung der Funktionsgruppe an den N*∩E Ligand und/oder an den Ligand L, entweder direkt oder über eine Brücke, sind dem Fachmann bekannt (Suzuki-, Still-, Heck-, Sonogashira-, Kumuda-, Ullmann-, Buchwald-Hartwig-Kupplung sowie deren Varianten; (Thio)Veretherung, Veresterung, nucleophile und elektrophile Substitutionen am $sp^3$-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

In einer besonderen Ausführungsform kann der Rest R auch ein elektronenleitender, lochleitender oder die Löslichkeit erhöhender Substituent sein.

Die Erfindung betrifft auch ein Verfahren zur Herstellung eines erfindungsgemäßen Kupfer(I)komplexes. Dieses erfindungsgemäße Verfahren weist den Schritt des Durchführens einer Reaktion von N*∩E und L mit Cu(I)X auf, wobei

X* = Cl, Br, I, CN, OCN, SCN, Alkinyl und/oder $N_3$ (unabhängig voneinander),

N*∩E = ein zweibindiger Ligand mit

E = Phosphanyl/Arsenyl/Antimonyl-Rest der Form $R_2E$ (mit R = Alkyl, Aryl, Alkoxyl, Phenoxyl, oder Amid);

N* = Imin-Funktion, die Bestandteil einer aromatische Gruppe ist, die ausgewählt ist aus Pyridyl, Pyrimidyl, Pyridazinyl, Triazinyl, Oxazolyl, Thiazolyl, Imidazolyl, Pyrazol, Isoxazol, Isothiazol, 1,2,4-Triazole, 1,2,4-Oxadiazole, 1,2,4-Thiadiazole, Tetrazole, 1,2,3,4-Oxatriazole und/oder 1,2,3,4-Thiatriazole, etc,

"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet, und L ausgestaltet sein: entweder als zwei einzähnige Liganden $DR_3$ mit

D = Phosphanyl/Arsenyl/Antimonyl-Rest der Form $R_3D$ (mit R = Alkyl, Aryl, Alkoxyl, Phenoxyl, oder Amid)

oder als ein zweizähniger Ligand $R_2D$-B-$DR_2$ mit

D = Phosphanyl/Arsenyl/Antimonyl-Rest der Form $R_2D$ (mit R = Alkyl, Aryl, Alkoxyl, Phenoxyl, oder Amid), die über eine Brücke B mit einem weiteren Rest D verbunden ist, wobei die Brücke B eine Alkylen- oder Arylen-Gruppe oder eine Kombination beider, oder -O-, -NR- oder - $SiR_2$- ist.

Der optional am Liganden N*∩E und/oder L vorhandene mindestens eine Substituent zur Erhöhung der Löslichkeit des Komplexes in organischen Lösungsmitteln und/oder zur Verbesserung des Ladungsträgertransports ist weiter unten beschrieben.

Die Reaktion wird bevorzugter Weise in Dichlormethan (DCM) durchgeführt. Durch die Zugabe von Diethylether zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen P∩N*-Liganden (P∩N* = Phosphan-Ligand, Definition s. u.) und L mit Cu(I)X (X = Cl, Br, I), bevorzugt in Dichlormethan (DCM), bevorzugt bei Raumtemperatur, entsteht- überraschend der zweikernige 2:3-Komplex $Cu_2X_2$(E∩N*)$L_2$, in dem die Cu-Atome durch einen Phosphanligand sowie die beiden Halogenid-Anionen überbrückt werden (G1. 1).

Die Struktur der Formel A ist verwandt mit bekannten Komplexen der Form $Cu_2X_2L_2L'$ bzw. $Cu_2X_2L_4$. Anders als bei $Cu_2X_2L_2L'$ ist der Komplex jedoch in nur einem Schritt durch Umsetzung von Cu(I)X mit dem zweizähnigen P∩N* Liganden und entweder zwei einzähnigen Liganden $DR_3$ oder einem zweizähnigen Liganden $R_2D$-B-$DR_2$ zugänglich. Der Komplex kann durch Fällen mit $Et_2O$ als gelbes oder rotes mikrokristallines Pulver isoliert werden. Einkristalle können durch langsames Eindiffundieren von $Et_2O$ in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

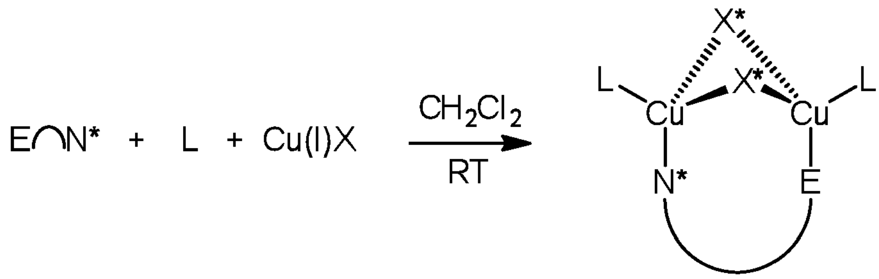


Gl. 1

Hierbei handelt es sich um die oben aufgeführte allgemeine Formel A. Die zweizähnigen E∩N*-Liganden und/oder entweder die zwei einzähnigen Liganden $DR_3$ oder der zweizähnige Ligand $R_2D$-B-$DR_2$ können unabhängig voneinander mindestens einen Substituenten umfassen: Die Substituenten können jeweils unabhängig voneinander Wasserstoff, Halogen sein oder Substituenten, die über Sauerstoff- (-OR), Stickstoff- (-$NR_2$) oder Siliziumatome (-$SiR_3$) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und $CF_3$-Gruppen. Die Substituenten können auch zu anellierten Ringsystemen führen.

Ein erfindungsgemäßer Kupfer(I)komplex besteht bevorzugt aus einem zweibindigen Liganden N*∩E und entweder zwei identischen einzähnigen Liganden $DR_3$ oder einem zweizähnigen Liganden $R_2D$-B-$DR_2$, wodurch unterschiedliche Funktionalitäten über die Peripherie der verschiedenen Liganden eingeführt werden können (beispielsweise je eine Lochtransport- und Elektrontransport-Einheit, im Folgenden als Loch- bzw. Elektronenleiter bezeichnet) und somit ein optimaler Ladungsträgertransport zu und eine wohldefinierte Rekombination direkt auf dem Kupferkomplex gewährleistet wird.. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Substituenten zur Einführung unterschiedlicher Funktionalitäten

Die oben genannten Substituenten zur Einführung unterschiedlicher Funktionalitäten über die verschiedenen Liganden (beispielsweise Loch- und/oder Elektronenleiter) zur Gewährleistung eines guten Ladungsträgertransports durch eine wohldefinierte Rekombination direkt auf dem Kupferkomplex, können entweder einfach oder mehrfach am E∩N*- und /oder L-Liganden gebunden sein. Es können identische oder unterschiedliche Funktions-Gruppen verwendet werden. Die Funktions-Gruppen können symmetrisch oder unsymmetrisch vorhanden sein.

Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumuda-, Ullmann-, Buchwald-Hartwig-Kupplung sowie deren Varianten zu Einsatz.

Dabei geht man von einem mit Halogenid (Cl, Br, I), insbesondere Br, substituierten E∩N*- und /oder L-Liganden aus und setzt diesen mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und E∩N*- und/oder L-Ligand. Bei Anwesenheit von -OH Gruppen kommen hier z. B. Veresterungen und Etherbildung in Frage, bei - $NH_2$ Gruppen Imin- und Amidbildung, bei -COOH Gruppen Esterbildung. Entsprechend muss das Subsitutionsmuster des E∩N*- und/oder L-Ligand angepasst werden. Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

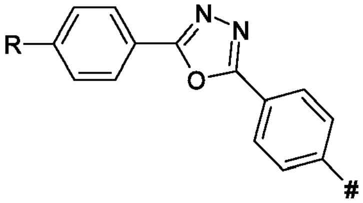

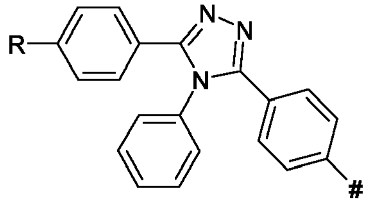

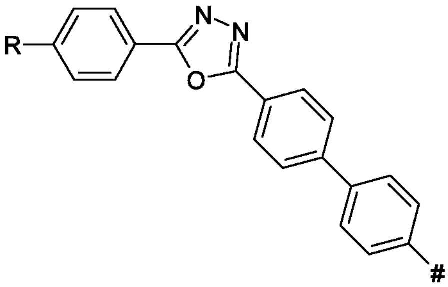

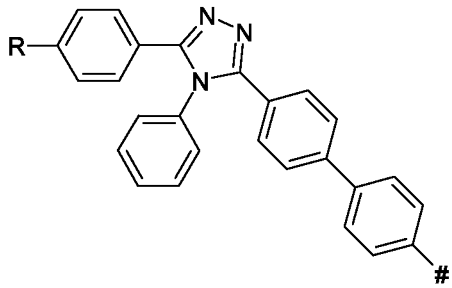

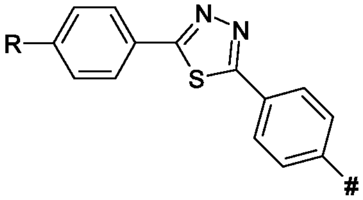

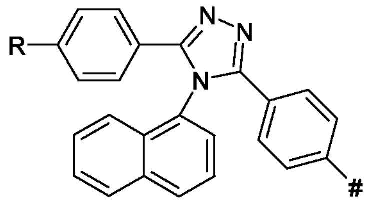

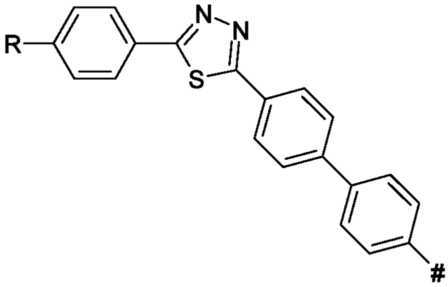

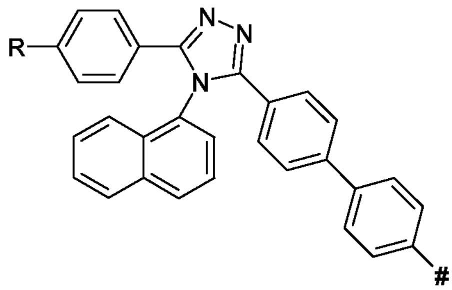

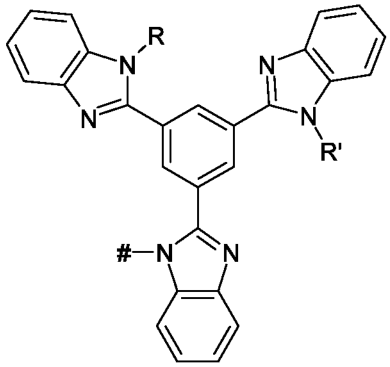

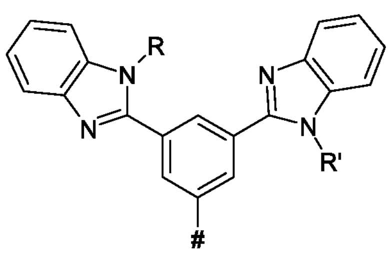

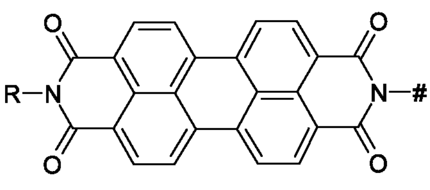

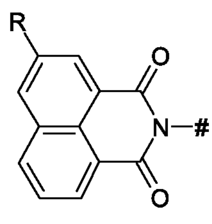

Bei den Substituenten R und R' handelt es sich um einen Alkyl-Rest [$CH_3$-$(CH_2)_{n-}$] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR'"3) oder Ethergruppen -OR"' (R"' definiert wie R; die hier verwendeten Substituenten entsprechen nicht notwendiger Weise den Substituenten R, R', R" der Formel I oder II) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"3) oder Ethergruppen -OR" (R" definiert wie R) substituiert sein können.

Lochleiter

Für den Lochleiter gelten analog die gleichen Aussagen wie für die Elektronenleiter. Auch hier wird die Verknüpfung des Lochleiters an den E∩N*- und/oder L-Liganden am einfachsten durch Palladium-katalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

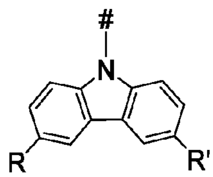
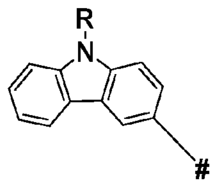
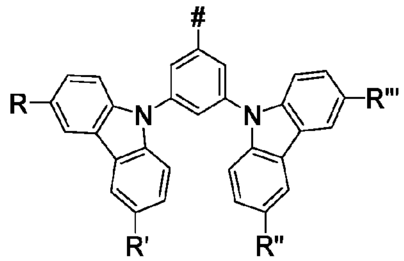
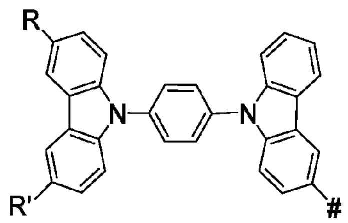
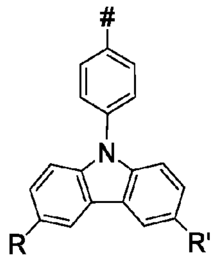
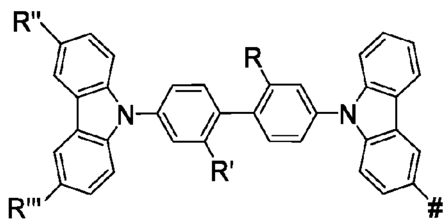
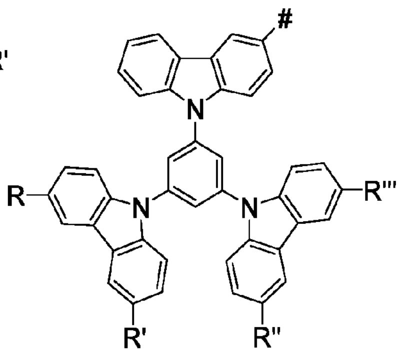

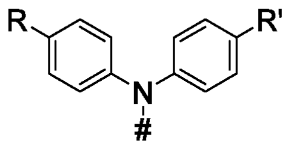

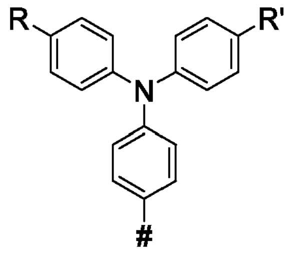

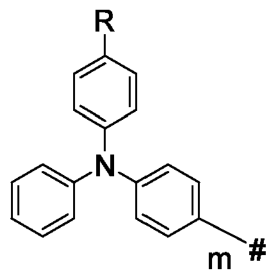

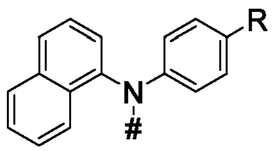

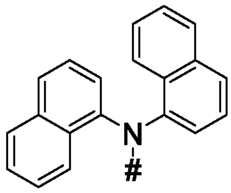

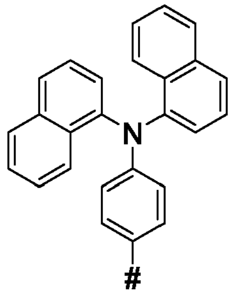

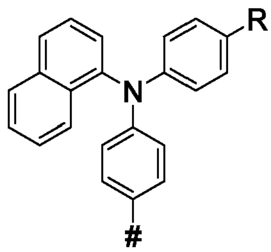

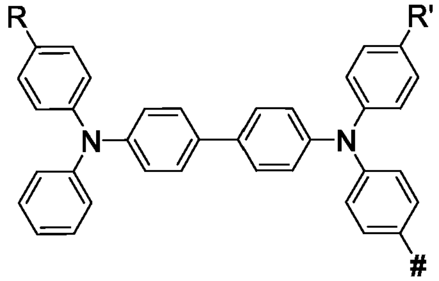

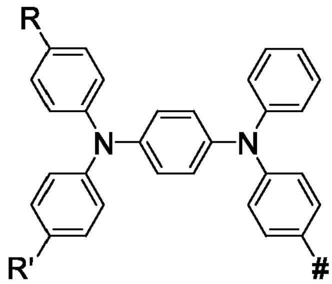

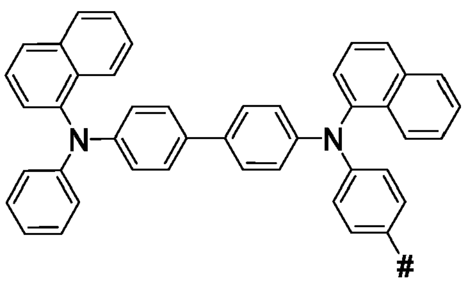

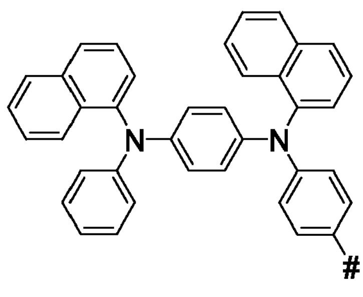

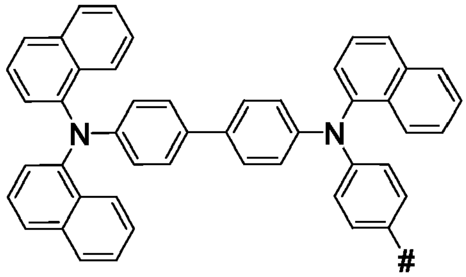

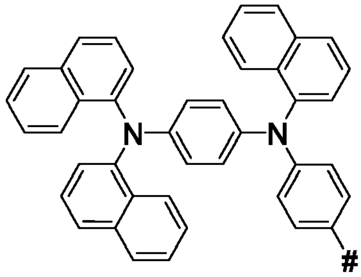

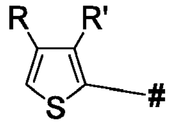

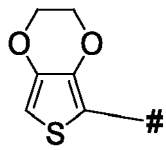

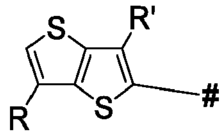

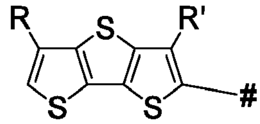

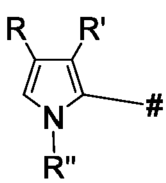

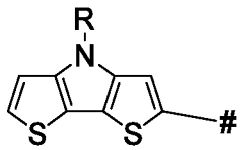

Bei den oben gezeigten Substituenten R, R" und R"' handelt es sich um einen Alkyl-Rest $[CH_3-(CH_2)_n-]$ (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR""$_3$) oder Ethergruppen -OR"" (R"" definiert wie R; die oben für die Lochtransport-Substituenten verwendeten Substituenten entsprechen nicht notwendiger Weise den Substituenten R, R', R" der Formel I oder II) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"$_3$) oder Ethergruppen -OR" (R" definiert wie R) substituiert sein können.

Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R1-R5 so gewählt werden, dass sie eine Abstimmung der Löslichkeiten erlauben. Folgende Möglichkeiten zur Auswahl entsprechender Substituenten sind gegeben:

Löslichkeit in unpolaren Medien

Unpolare Substitutenten R1-R5 erhöhen die Löslichkeit in unpolaren Lösungsmitteln und erniedrigen die Löslichkeit in polaren Lösungsmitteln. Unpolare Gruppen sind z. B. Alkylgruppen $[CH_3-(CH_2)_n-]$ (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. $[-(CF_2)_2-O]_n$ - und $(-CF_2-O)_n-$ (n = 2 - 500). Weitere unpolare Gruppen sind: Ether -OR*, Thioether -SR*, unterschiedlich substituierte Silane $R^*_3Si-$(R* = Alkyl oder Aryl), Siloxane $R^*_3Si-O-$, Oligosiloxane $R^{**}(-R_2Si-O)_n-$ (R** = R*, n = 2 - 20), Polysiloxane $R^{**}(-R^*_2Si-O)_n-$ (n > 20); Oligo/

polyphosphazene $R^{**}(-R^*_2P{=}N-)_n-$ (n = 1 - 200).

Löslichkeit in polaren Medien

Polare Substitutenten R1-R5 erhöhen die Löslichkeit in polaren Lösungsmitteln. Diese können sein:

- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
  - COOH, $-P(O)(OH)_2$, $-P(S)(OH)_2$, $-S(O)(OH)_2$, -COOR*, $-P(O)(OR^*)_2$, $-P(S)(OR^*)_2$ ,$-S(O)(OR^*)_2$, -CONHR*, $-P(O)(NR^*_2)_2$, $-P(S)(NR^*_2)_2$ , $-S(O)(NR^*_2)_2$
- Sulfoxide: -S(O)R*, $-S(O)_2R^*$
- Carbonylgruppen: -C(O)R*
- Amine: $-NH_2$, $-NR^*_2$, $-N(CH_2CH_2OH)_2$,
- Hydroxylamine =NOR*
- Oligoester, $-O(CH_2O-)_n$, $-O(CH_2CH_2O-)_n$ (n = 2 - 200)
- Positiv geladene Substituenten: z. B. Ammonium-Salze $-N^+R^*_3X^-$ , Phosphonium-Salze - $P^+R^*3X^-$
- Negativ geladene Substituenten, z. B. Borate $-(BR^*_3)^-$, Aluminate $-(AlR^*_3)^-$ (als Anion kann ein Alkalimetal oder Ammoniumion fungieren).

Optional kann das Darstellungsverfahren den Schritt umfassen, dass mindestens ein Ligand N*∩E und/oder L mit mindestens einem der oben genannten Substituenten zur Erhöhung der Löslichkeit in einem organischen Lösungsmittel substituiert wird, wobei der Substituent in einer Ausführungsform der Erfindung ausgewählt sein kann aus der Gruppe bestehend aus:

- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Optional kann das Darstellungsverfahren den Schritt umfassen, dass mindestens ein Ligand N*∩E und/oder L mit mindestens einer der o. g. funktionellen Gruppe zur Verbesserung des Ladungsträgertransports und zur Erhöhung der Rekombinationswahrscheinlichkeit der Ladungsträger direkt auf den erfindungsgemäßen Kupfer(I)komplexen substituiert wird, wobei die funktionelle Gruppe am Ligand N*∩E gleich oder verschieden sein kann von der funktionellen Gruppe am Ligand L, bevorzugt verschieden, wobei der Substituent in einer Ausführungsform der Erfindung ausgewählt sein kann aus der Gruppe bestehend aus Elektronenleiter und Lochleiter.

Erfindungsgemäß sind auch Kupfer(I)komplexe, die durch ein derartiges Syntheseverfahren herstellbar sind.

Die Kupfer(I)komplexe der Formel A können erfindungsgemäß als Emitter-Materialien unter Einbeziehung des Triplett-Zustandes in einer Emitterschicht eines Licht-emittierenden optoelektronischen Bauelements eingesetzt werden.

Die Kupfer(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:

- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Vorteilhafter Weise beträgt die Konzentration des Kupfer(I)komplexes als Emitter in optischen Licht emittierenden Bauelementen, insbesondere in OLEDs, zwischen 1 % und 10 %.

Gegenstand der vorliegenden Erfindung sind auch optoelektronische Bauelemente, die einen hier beschriebenen Kupfer(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Kupfer(I)komplex der hier beschriebenen Art verwendet wird. Bei diesem Verfahren wird insbesondere ein erfindungsgemäßer Kupfer(I)komplex auf einen Träger aufgebracht. Dieses Aufbringen kann nass-chemisch, mittels kolloidaler Suspension oder mittels Sublimation erfolgen, insbesondere nass-chemisch. Das Verfahren kann die folgenden Schritte aufweisen:

Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Kupfer(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Kupfer(I)komplex ein erfindungsgemäßer Kupfer(I)komplex ist. Erstes und zweites Lösungsmittel sind dabei nicht identisch.

Die vorliegende Erfindung betrifft auch ein Verfahren zur Veränderung der Emissions- und/oder Absorptionseigenschaften eines elektronischen Bauelements. Dabei wird ein erfindungsgemäßer Kupfer(I)komplex in ein Matrixmaterial zur Leitung von Elektronen oder Löchern in ein optoelektronisches Bauelement eingebracht.

Die vorliegende Erfindung betrifft auch die Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer bevorzugten Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist bevorzugt ein erfindungsgemäßer Kupfer(I)komplex.

Da die erfindungsgemäßen Kupfer(I)komplexe mit unsubstituierten Liganden N*∩E in einigen organischen Lösungsmitteln z. T. schwer löslich sind, können sie ggf. nicht direkt aus Lösung verarbeitet werden. Bei Lösungsmitteln, die ihrerseits gute Liganden darstellen (Acetonitril, Pyridin) ist zwar eine gewisse Löslichkeit gegeben, jedoch kann eine Änderung der Struktur der Komplexe oder eine Verdrängung der Phosphan-, Arsan- oder Antimon-Liganden unter diesen Bedingungen nicht ausgeschlossen werden. Daher ist nicht klar, ob die Substanzen bei einer Abscheidung auf dem Substrat als $Cu_2X_2(E\cap N^*)(L)_2$ kristallisieren bzw. ob sie in der Matrix in dieser Form molekular vorliegen werden. Aus diesem Grund sollten die Substanzen in einer für die Anwendung in optoelektronischen Bautelementen geeigneten Größe hergestellt bzw. auf diese zerkleinert werden (< 20 nm bis 30 nm, Nanopartikel) oder mittels geeigneter Substituenten löslich gemacht werden.

Die erfindungsgemäßen Kupfer(I)komplexe werden bevorzugt aus Lösung prozessiert, da das hohe Molekulargewicht eine Abscheidung aus dem Vakuum durch Sublimation erschwert. Somit erfolgt die Herstellung der photoaktiven Schichten bevorzugt aus Lösung durch Spincoating oder Schlitzgießverfahren oder mit einem beliebigen Druckverfahren wie Siebdruck, Flexodruck, Offsetdruck oder Ink-Jet-Druck.

Die hier beschriebenen unsubstituierten Kupfer(I)komplexe (Definition weiter unten, siehe Beispiele) sind jedoch in den gängigen organischen Lösungsmitteln, außer in Dichlormethan, welches zur OLED-Bauteilherstellung in einer Glovebox nicht verwendet werden sollte, schwer löslich. Das Aufbringen als kolloidale Suspension ist in vielen Fällen sinnvoll (siehe weiter unten), allerdings ist eine technische Verarbeitung der Emittermaterialien in gelöster Form meist technisch einfacher. Daher ist ein weiteres Ziel dieser Erfindung, die Emitter chemisch so zu verändern, dass diese löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon

Um die Löslichkeit der erfindungsgemäßen Kupfer(I)komplexe in organischen Lösungsmitteln zu verbessern, ist mindestens eine der Strukturen N*∩E und/oder L in bevorzugter Weise mit mindestens einem der oben genannten Substituenten substituiert. Der Substituent kann ausgewählt sein aus der Gruppe bestehend aus:

- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt

mit einer Länge von C3 bis C20, besonders bevorzugt mit einer Länge von C5 bis C15,

- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form $(-OCH_2CH_2O-)_n$, mit n < 500. Beispiele hierfür sind Polyethylenglykole (PEG), die als chemisch inerte, wasserlösliche und nicht-toxische Polymere mit einer Kettenlänge von 3-50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C6-Einheit, verzweigt oder unverzweigt oder zyklisch, erreicht.

Um den Ladungsträgertransport und die Rekombinationswahrscheinlichkeit der Ladungsträger direkt auf den erfindungsgemäßen Kupfer(I)komplexen zu verbessern, ist mindestens eine der Strukturen $N^*\cap E$ und/oder L in bevorzugter Weise mit mindestens einer der oben genannten funktionellen Gruppe zur Verbesserung des Ladungsträgertransports substituiert, wobei die funktionelle Gruppe am Ligand $N^*\cap E$ gleich oder verschieden sein kann von der funktionellen Gruppe am Ligand L, bevorzugt verschieden. Der Substituent kann ausgewählt sein aus der Gruppe bestehend aus Elektronenleiter und Lochleiter.

Die Substituenten der Strukturen $N^*\cap E$ und/oder L der Kupfer(I)komplexe können an jeder Stelle der Struktur angeordnet sein. Insbesondere ist eine Stellung des Substituenten in ortho-, meta-und/oder para-Stellung zu dem die Koordination zum Cu-Ion ausbildenden Heteroatom möglich. Bevorzugt ist eine Substitution in meta- und/oder para-Stellung.

Ein weiterer Aspekt der Erfindung betriff die Veränderung der Emissionsfarben der Kupfer(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:

- Alkyl, -Phenyl, $-CO_2(-)$, -O(-), -NH-Alkylgruppe, $-N(Alkylgruppe)_2$, $-NH_2$, -OH, -O-Alkylgruppe, -NH(CO)-Alkylgruppe, -O(CO)-Alkylgruppe, -O(CO)-Arylgruppe, -O(CO)-Phenylgruppe, -(CH)=C-(Alkylgruppe)2, -S-Alkylgruppe

Beispiele für elektronenziehende Substituenten sind insbesondere:

- Halogen, -(CO)H, -(CO)-Alkylgruppe, -(CO)O-Alkylgruppe, -(CO)OH, -(CO)Halogenid, $-CF_3$, -CN, $-SO_3H$, $-NH_3(+)$, $-N(Alkylgruppe)_3(+)$, $-NO_2$

Vorteilhafter Weise sind die elektronenschiebenden und -ziehenden Substituenten möglichst weit von der Koordinationsstelle des Liganden entfernt, insbesondere in meta- oder para-Stellung.

Somit kann durch geeignete Substitutionswahl innerhalb der Grundstruktur eines Pyridinliganden ein sehr breiter Emissionsfarbbereich eingestellt werden.

Die Veränderung der Emissionsfarben der hier beschriebenen Kupfer(I)komplexe kann auch durch weitere Heteroatome wie N, O, S, sowie mittels kondensierter N-, O- und S-Heteroaromaten erfolgen.

Die Verwendung kondensierter N-Heteroaromaten wie beispielsweise Isoquinolin, Benzothiazol, Chinoxalin, ermöglicht Farbverschiebungen, zum Beispiel in den gelben bis tiefroten Spektralbereich. Die Erhöhung der Löslichkeit von Kupfer(I)komplexen mit kondensierten N-Heteroaromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer bevorzugten Ausführungsform weist der erfindungsgemäße Kupfer(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Mittels einer modularen Synthesestrategie, in der die Einzelbausteine zur Darstellung dieser Liganden in einer Matrix miteinander kombiniert werden, ist die Einführung von unterschiedlich langen, linearen und verzweigten und zyklischen Alkylketten, Alkoxyketten oder Perfluoralkylketten an verschiedenen Positionen der Moleküle möglich. Bevorzugt sind Substitutionen, die weit entfernt sind von der Koordinationsstelle des oder der Liganden N*∩E und/oder L.

Ausgehend von einem geeigneten Synthesebaustein A werden in analogen Reaktionen unterschiedliche Reaktanden B, C und D unter analogen Reaktionsbedingungen zu chemisch diversen Zielmolekülen AB, AC und AD verknüpft. Hierdurch lassen sich beispielsweise unterschiedlich lange Alkylketten durch Verwendung nukleophiler Substitutionsreaktionen modular an einen geeigneten Pyridinliganden anbringen

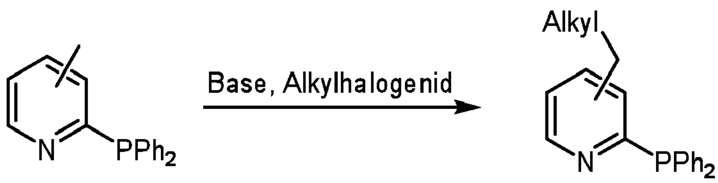


Für die Herstellung der oben genannten Nanopartikel kleiner als 30 nm können mehrere Techniken angewandt werden: [xxii]

*Bottom-Up-Prozesse* zur Synthese von Nanopartikeln:

- schnelle Injektion der Reaktionslösung in einen großen Überschuss eines geeigneten Fällungsmittel (z. B. Pentan, Diethylether).[xxiii]
- Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
- Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
- Co-Abscheidung der Komplexe und des Matrixmaterials auf dem Substrat direkt aus der Reaktionslösung.
- Synthese im Ultraschall-Bad.

*Top-Down*-Prozesse zur Zerkleinerung der Substanzen:

- Zerkleinerung durch Hochenergiekugelmühlen. [xxiv]
- Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der Nanopartikel in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und die Nanopartikel auf ein Substrat aufgebracht werden. Um eine Aggregation der Nanopartikel zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen sogar als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

**Beispiele**

In den hier gezeigten Beispielen ist der Ligand E∩N* der allgemeinen Formel A ein Ligand P∩N* (mit E = $Ph_2P$).

**Beispiele für Komplexe der Form $Cu_2X_2(P\cap N^*)L_2$**

## I. P∩N* = $Ph_2Ppic$, L = $PPh_3$: $Cu_2I_2(Ph_2Ppic)(PPh_3)_2$ (1)

Bei der Verbindung 1 handelt es sich um einen gelben, feinkristallinen Feststoff.

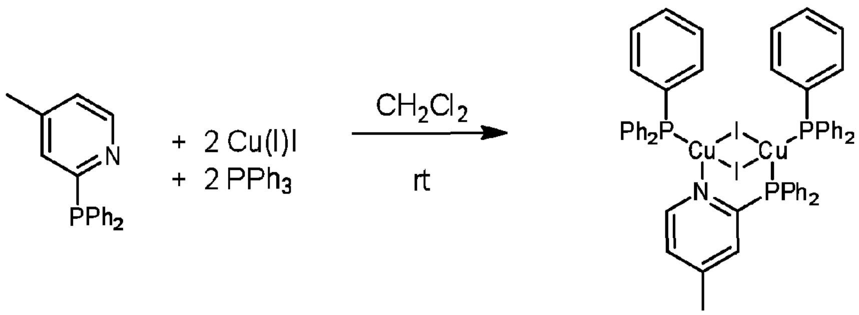


Gl. 3

Charakterisierung:

Elementaranalyse:

gef.: C 54.45; H 4.04; N 0.79
ber.: C 54.84; H 3.92; N 1.18

Die Kristallstruktur ist in Fig. 1A gezeigt

Das Emissionsspektrum ist in Fig. 1B gezeigt

## II. P∩N* = $Ph_2Ppic$, L = $P(p\text{-}Tol)_3$: $Cu_2I_2(Ph_2Ppic)(P(p\text{-}Tol)_3)_2$ (2)

Bei 2 handelt es sich um einen gelben, feinkristallinen Feststoff.

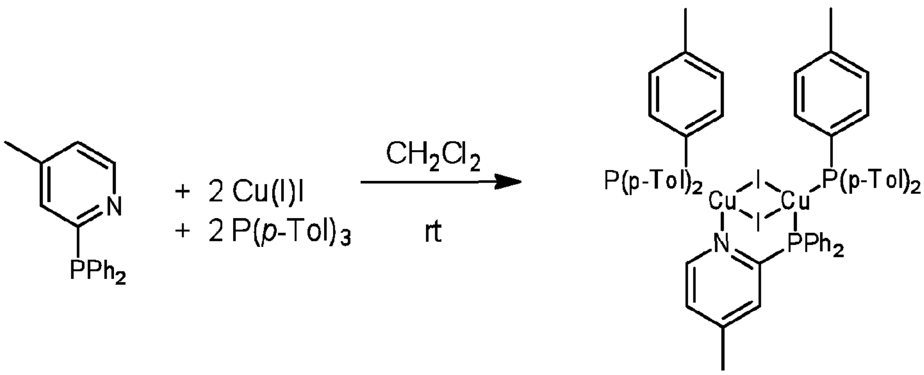


Gl. 4

Charakterisierung:

Elementaranalyse:

gef.: C 53.88; H 4.44; N 0.86
ber.: C 54.20; H 4.47; N 1.04

Das Emissionsspektrum ist in Fig. 2 gezeigt

## III. P∩N* = $Ph_2Pic$, L = $EtPPh_2$: $Cu_2I_2(Ph_2Pic)(EtPPh_2)_2$ (3)

Bei der Verbindung 3 handelt es sich um einen gelben, feinkristallinen Feststoff.

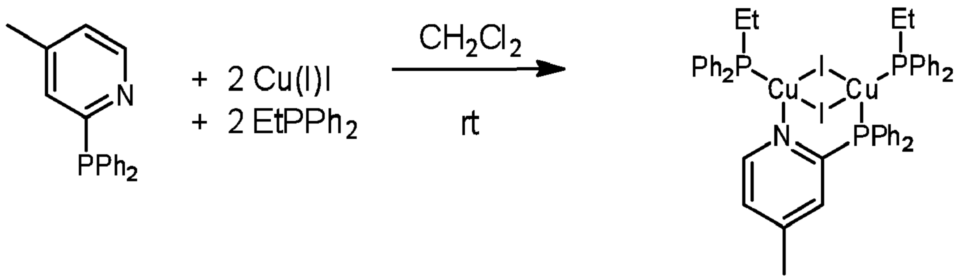


Gl. 5

Charakterisierung:

Elementaranalyse:

gef.: C 50.70; H 4.28; N 1.20
ber.: C 50.84; H 4.27; N 1.29

Das Emissionsspektrum ist in Fig. 3 gezeigt

## IV. P∩N* = $Ph_2P(2\text{-}Mepy)$, L = $PPh_3$: $Cu_2I_2(Ph_2P(2\text{-}Mepy))(PPh_3)_2$ (4)

Bei der Verbindung 4 handelt es sich um einen gelben, feinkristallinen Feststoff.

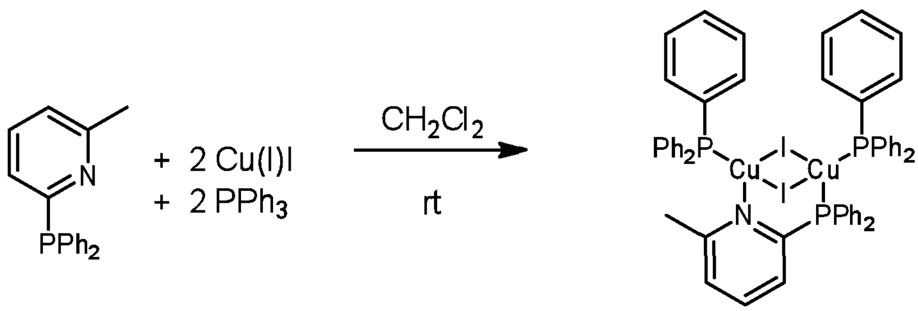


Charakterisierung:

Elementaranalyse:

gef.: C 48.06; H 3.68; N 0.91
ges.: C 47.62; H 3.65; N 0.97

Das Emissionsspektrum ist in Fig. 4 gezeigt

## V. P∩N* = $Ph_2P$(iBupy), L = $PPh_3$: $Cu_2I_2(Ph_2P(iBupy))(PPh_3)_2$ (5)

Bei der Verbindung 5 handelt es sich um einen gelben, feinkristallinen Feststoff.

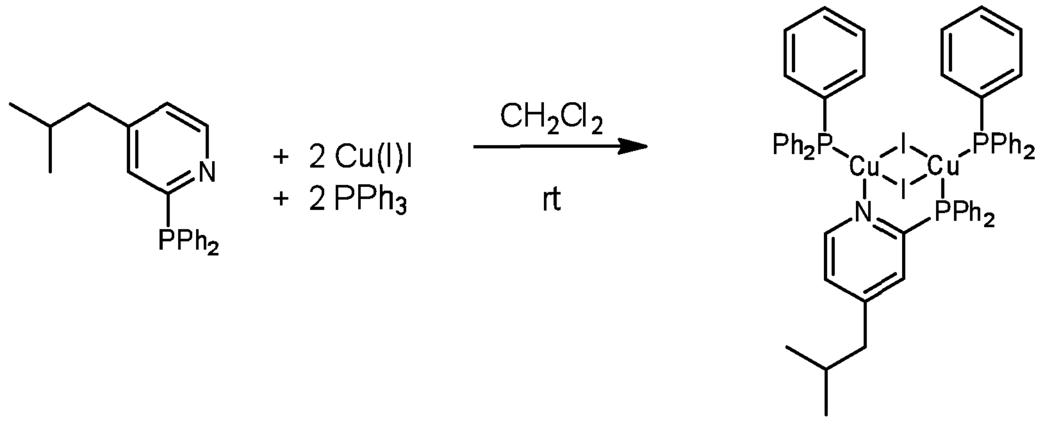


Charakterisierung:

Elementaranalyse:

gef.: C 56.55; H 4.80; N 0.75
(mit ½ Molekül n-Hexan)
ber.: C 56.84; H 4.69; N 1.10

Das Emissionsspektrum ist in Fig. 5 gezeigt

## VI. P∩N* = $Ph_2P$(cyPentpy), L = $PPh_3$: $Cu_2I_2(Ph_2P(cyPentpy))(PPh_3)_2$ (6)

Bei der Verbindung 6 handelt es sich um einen gelben, feinkristallinen Feststoff.

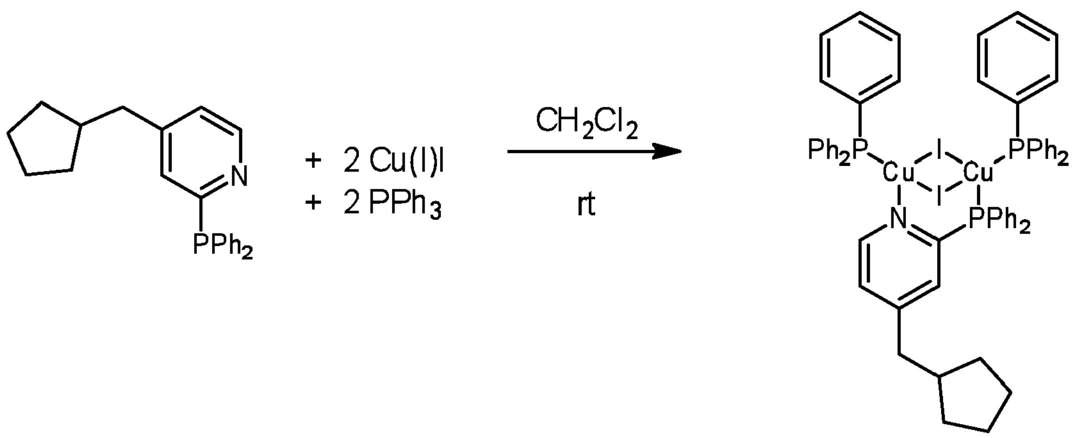


Charakterisierung:

Elementaranalyse:

gef.: C 57.19; H 5.08; N 0.69
(mit ¼ Molekül n-Hexan)
ber.: C 57.11; H 4.55; N 1.10

Das Emissionsspektrum ist in Fig. 6 gezeigt.

## VII. P∩N* = $Ph_2Piqn$, L = $PPh_3$: $Cu_2I_2(Ph_2Piqn)(PPh_3)_2$ (7)

Bei der Verbindung 7 handelt es sich um einen orangefarbenen, kristallinen Feststoff.

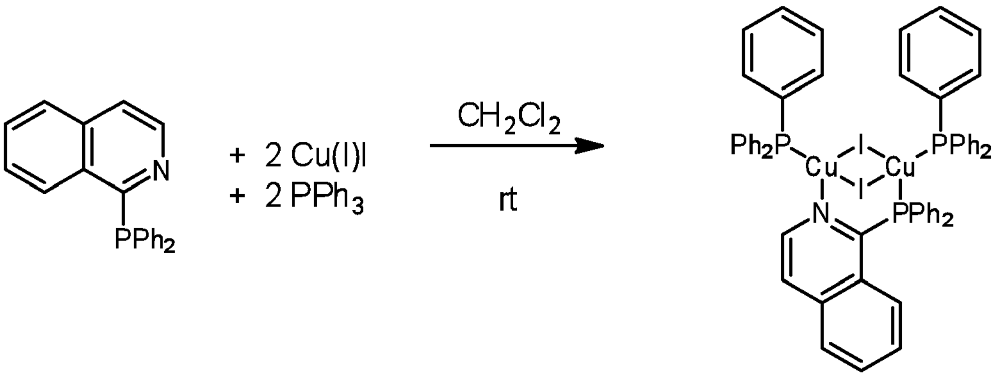


Charakterisierung:

Elementaranalyse:

gef.: C 57.15; H 3.92; N 1.29
(mit ½ Molekül n-Hexan)
ber.: C 57.11; H 4.23; N 1.11

Das Emissionsspektrum ist in Fig. 7 gezeigt

## VIII. P∩N* = $Ph_2P$(Oxadiazol), L = $PPh_3$: $Cu_2I_2(Ph_2P(Oxadiazol))(PPh_3)_2$ (8)

Bei der Verbindung 8 handelt es sich um einen gelben, feinkristallinen Feststoff.

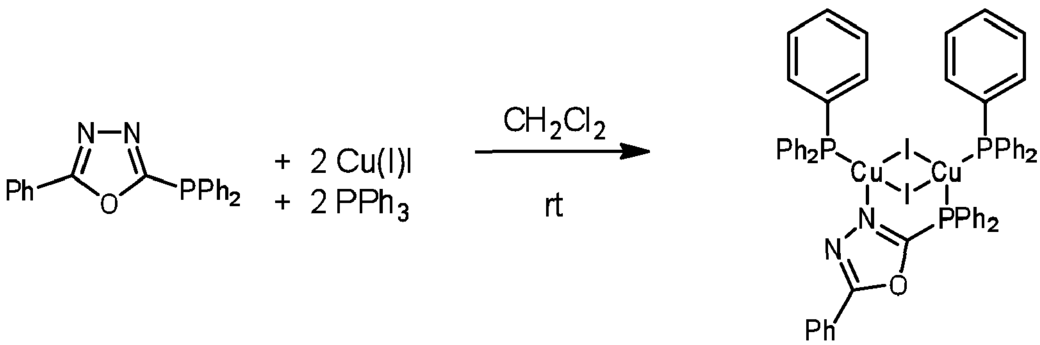


Charakterisierung:

Elementaranalyse:

gef.: C 54.45; H 4.07; N 1.97
ber.: C 54.43; H 3.67; N 2.27

Das Emissionsspektrum ist in Fig. 8 gezeigt.

## IX. P∩N* = $Ph_2P$(Oxadiazol), L = P(*p*-Tol)$_3$: $Cu_2I_2$($Ph_2P$(Oxadiazol))(P(*p*-Tol)$_3$)$_2$ (9)

Bei der Verbindung **9** handelt es sich um einen gelben, feinkristallinen Feststoff.

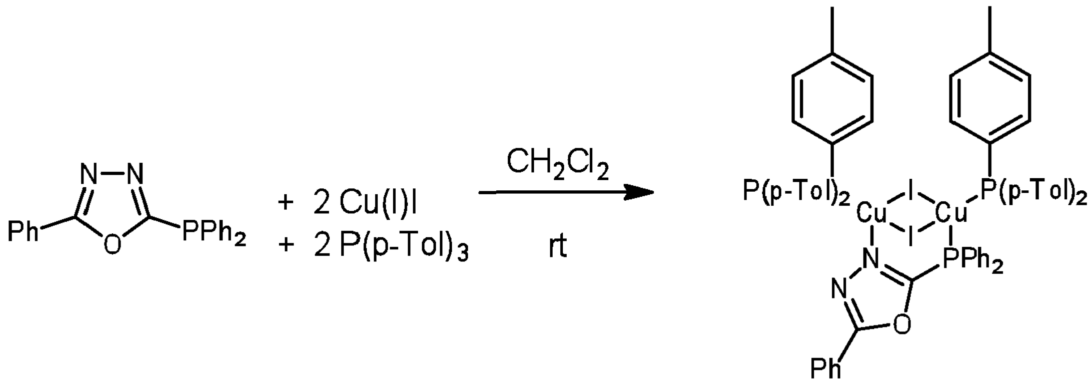


Charakterisierung:

Elementaranalyse:

gef.: C 55.80; H 4.16; N 2.54
ber.: C 56.42; H 4.35; N 2.12

Das Emissionsspektrum ist in Fig. 9 gezeigt.

## X. P∩N* = $Ph_2P$(Oxadiazol), L = $EtPPh_2$: $Cu_2I_2$($Ph_2P$(Oxadiazol))($EtPPh_2$)$_2$ (10)

Bei der Verbindung 10 handelt es sich um einen gelben, feinkristallinen Feststoff.

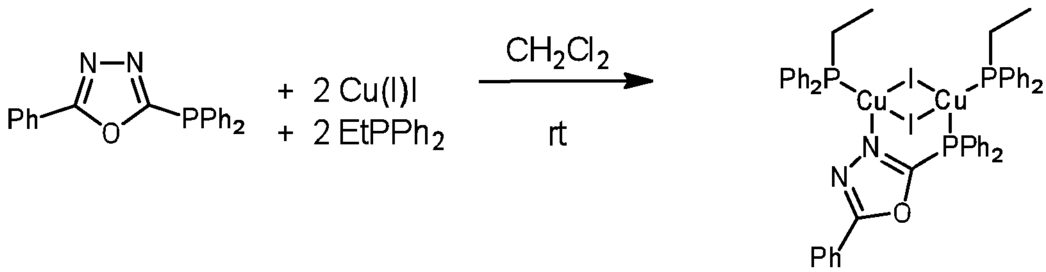


Charakterisierung:

Elementaranalyse:

gef.: C 50.05; H 3.83; N 2.70

ber.: C 49.92; H 3.95; N 2.41

Das Emissionsspektrum ist in Fig. 10 gezeigt.

## XI. P∩N* = $Ph_2P$(Oxadiazol), L = $MePPh_2$: $Cu_2I_2(Ph_2P(Oxadiazol))(MePPh_2)_2$ (11)

Bei der Verbindung **11** handelt es sich um einen gelben, feinkristallinen Feststoff.

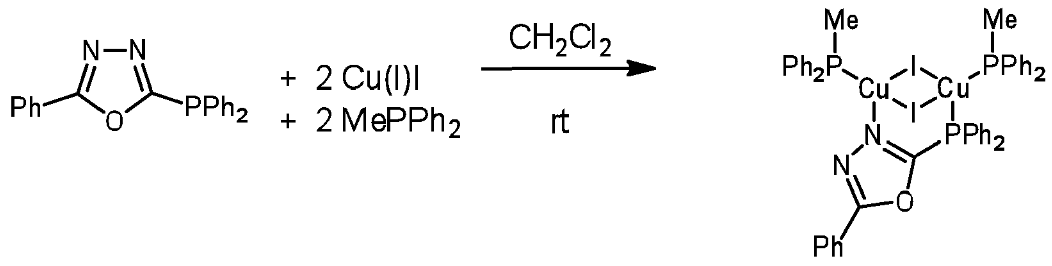


Charakterisierung:

Elementaranalyse:

gef.: C 50.18; H 3.98; N 2.25
ber.: C 49.70; H 3.72; N 2.52

Das Emissionsspektrum ist in Fig. 11 gezeigt.

## XII. P∩N* = $Ph_2P$(Oxadiazol), L = $PhP(CH_2CH_2PPh_2)_2$: $Cu_2I_2(Ph_2P(Oxadiazol))(PhP(CH_2CH_2PPh_2)_2)_2$ (12)

Bei der Verbindung 12 handelt es sich um einen gelben, feinkristallinen Feststoff.

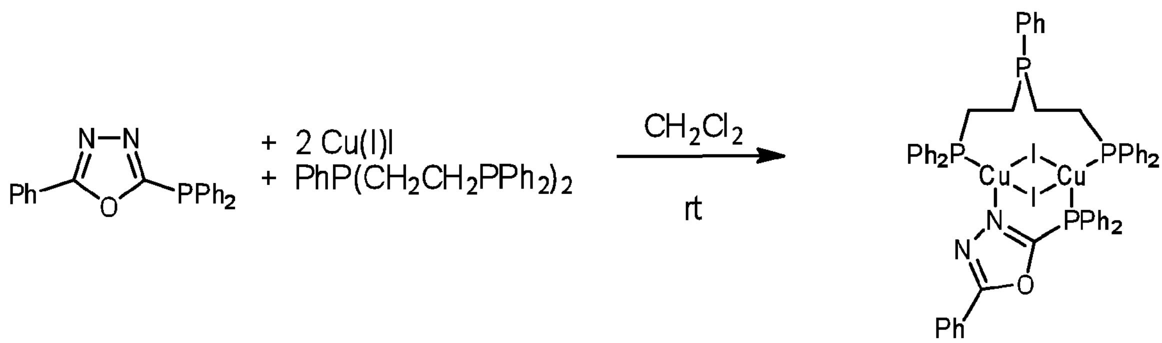


Charakterisierung:

Elementaranalyse:

gef.: C 49.84; H 3.76 N 1.67
(mit einem Molekül DCM)
ber.: C 49.64; H 3.79; N 2.11

Das Emissionsspektrum ist in Fig. 12 gezeigt.

## XIII. P∩N* = $Ph_2PMe_2Thiaz$, L = $PPh_3$: $Cu_2I_2(Ph_2PMe_2Thiaz)(PPh_3)_2$ (13)

Bei der Verbindung **13** handelt es sich um einen gelben, feinkristallinen Feststoff.

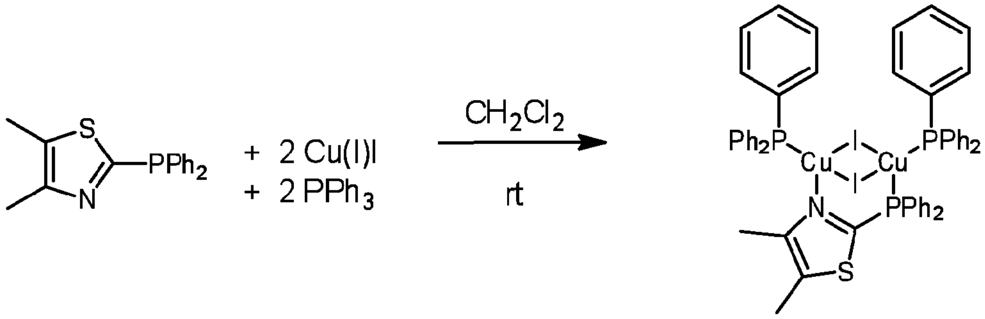


Charakterisierung:

Elementaranalyse:

gef.: C 52.54; H 4.07; N 1.86; S 2.19
ges.: C 52.92; H 3.85; N 1.16; S 2.67

Das Emissionsspektrum ist in Fig. 13 gezeigt.

## XIV. P∩N* = $Ph_2PThiaz$, L = $PPh_3$: $Cu_2I_2(Ph_2PThiaz)(PPh_3)_2$ (14)

Bei der Verbindung 14 handelt es sich um einen gelben, feinkristallinen Feststoff.

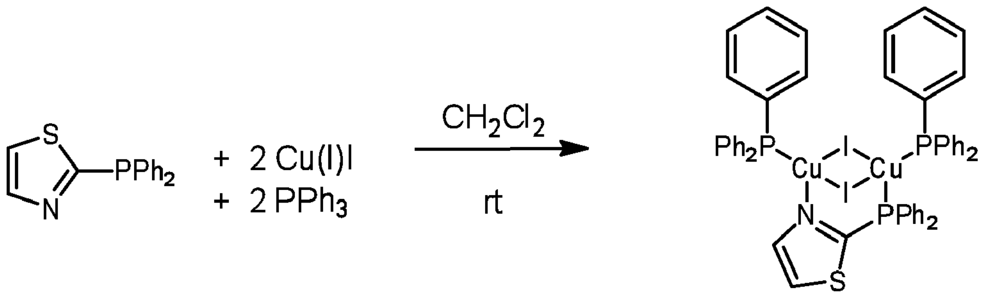


Charakterisierung:

Elementaranalyse:

gef.: C 52.14; H 3.65; N 1.01; S 2.43
ges.: C 52.14; H 3.60; N 1.19; S 2.73

Das Emissionsspektrum ist in Fig. 14 gezeigt.

## XV. P∩N* = $Ph_2P(Ph_2Triaz)$, L = $PPh_3$: $Cu_2I_2(Ph_2P(Ph_2Triaz))(PPh_3)_2$ (15)

Bei der Verbindung 15 handelt es sich um einen weißen, feinkristallinen Feststoff.

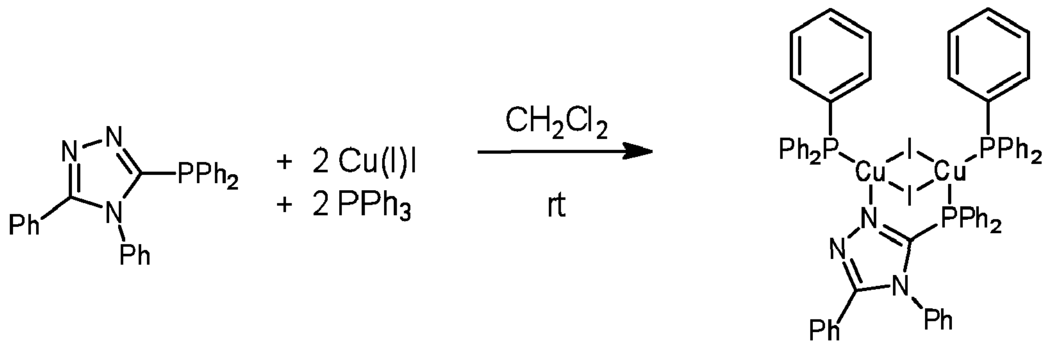


Charakterisierung:

Elementaranalyse:

gef.: C 55.89; H 3.74 ; N 2.70
ges.: C 56.13; H 3.82; N 3.15

Das Emissionsspektrum ist in Fig. 15 gezeigt.

## XVI. P∩N* = $Ph_2PTolTriaz$, L = $PPh_3$: $Cu_2I_2(Ph_2PTolTriaz)(PPh_3)_2$ (16)

Bei der Verbindung 16 handelt es sich um einen weißen, feinkristallinen Feststoff.

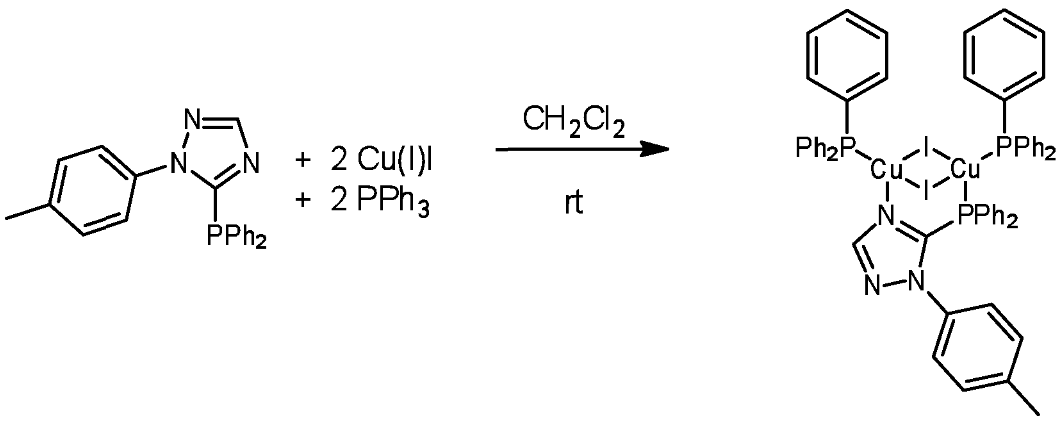


Charakterisierung:

Elementaranalyse:

gef.: C 54.26; H 4.05; N 3.36
ges.: C 54.14; H 3.85; N 3.31

Das Emissionsspektrum ist in Fig. 16 gezeigt.

## XVII. P∩N* = $Ph_2PPrTriaz$, L = $PPh_3$: $Cu_2I_2(Ph_2PPrTriaz)(PPh_3)_2$ (17)

Bei der Verbindung 17 handelt es sich um einen weißen, feinkristallinen Feststoff.

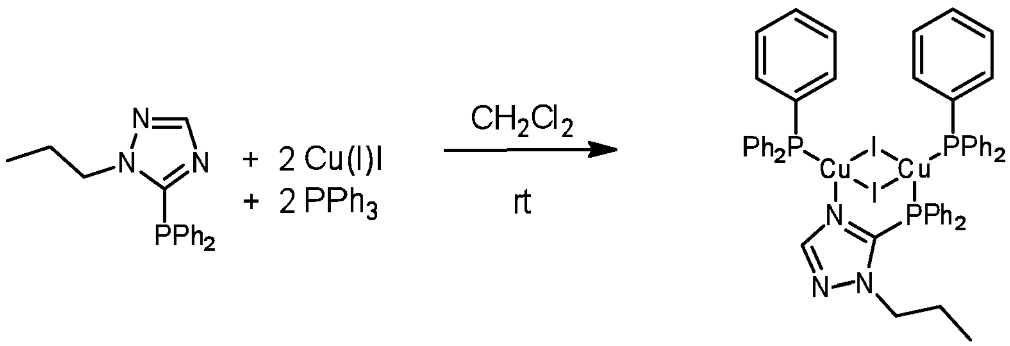


Charakterisierung:

Elementaranalyse:

gef.: C 52.77; H 4.05; N 3.11
ges.: C 53.01; H 4.03; N 3.50

Das Emissionsspektrum ist in Fig. 17 gezeigt.

## XVIII. P∩N* = $Ph_2PPentTriaz$, L = $PPh_3$: $Cu_2I_2(Ph_2PPentTriaz)(PPh_3)_2$ (18)

Bei der Verbindung 18 handelt es sich um einen weißen, feinkristallinen Feststoff.

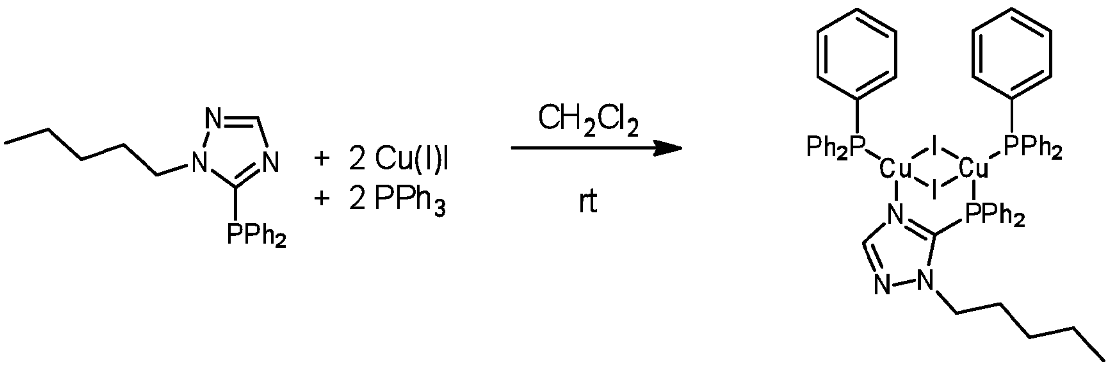


Charakterisierung:

Elementaranalyse:

gef.: C 53.55; H 4.34; N 3.65
ges.: C 53.76; H 4.27; N 3.42

Das Emissionsspektrum ist in Fig. 18 gezeigt.

## XIX. P∩N* = $Ph_2PEtHexTriaz$, L = $PPh_3$: $Cu_2I_2(Ph_2PEtHexTriaz)(PPh_3)_2$ (19)

Bei der Verbindung 19 handelt es sich um einen weißen, feinkristallinen Feststoff.

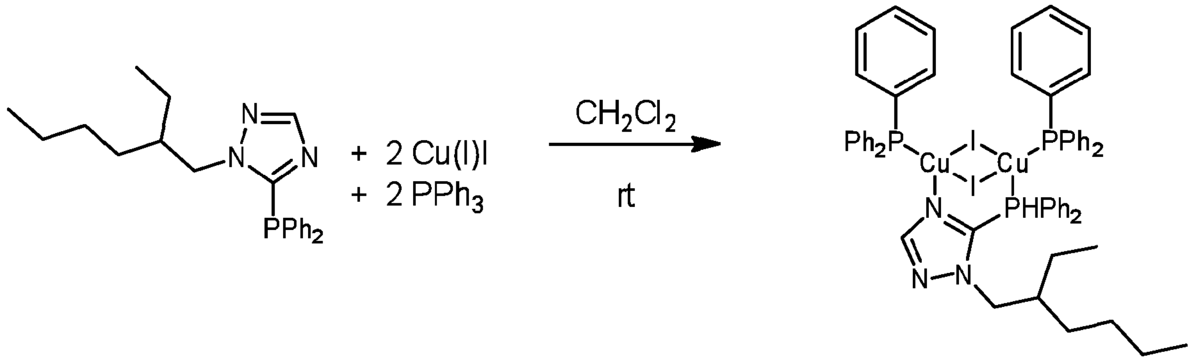


Charakterisierung:

Elementaranalyse:

gef.: C 53.70; H 4.36; N 2.63
ges.: C 53.50; H 4.53; N 3.20

Das Emissionsspektrum ist in Fig. 19 gezeigt.

## XX. P∩N* = $Ph_2PBnTriaz$, L = $PPh_3$: $Cu_2I_2(Ph_2PBnTriaz)(PPh_3)_2$ (20)

Bei der Verbindung 20 handelt es sich um einen weißen, feinkristallinen Feststoff.

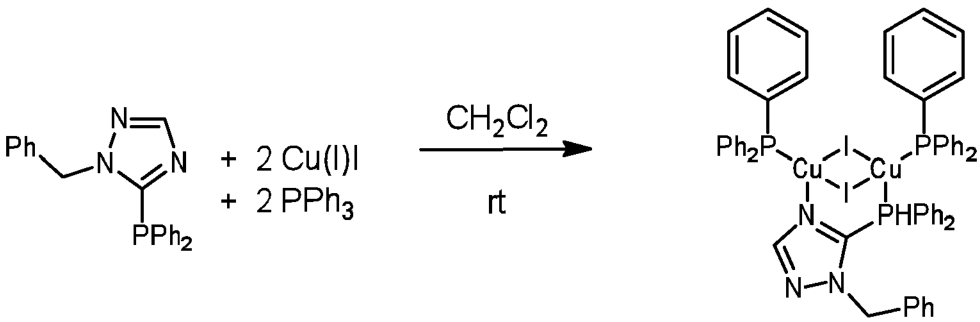


Charakterisierung:

Elementaranalyse:

gef.: C 54.67; H 3.78; N 3.28
ges.: C 54.82; H 3.87; N 3.36

Das Emissionsspektrum ist in Fig. 20 gezeigt.

## XXI. P∩N* = $Ph_2P(MeImid)$, L = $PPh_3$: $Cu_2I_2(Ph_2P(MeImid))(PPh_3)_2$ (21)

Bei der Verbindung 21 handelt es sich um einen weißen, feinkristallinen Feststoff.

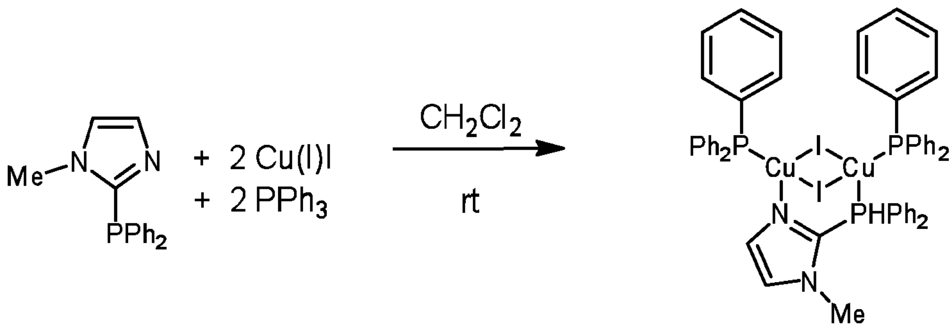


Charakterisierung:

Elementaranalyse:

gef.: C 52.38; H 3.84; N 2.33
(mit 1/3 Molekül DCM)
ges.: C 52.39; H 3.90; N 2.28

Das Emissionsspektrum ist in Fig. 21 gezeigt.

## XXII. P∩N* = $Ph_2P(MeTolImid)$, L = $PPh_3$: $Cu_2I_2(Ph_2P(MeTolImid))(PPh_3)_2$ (22)

Bei der Verbindung 22 handelt es sich um einen weißen, feinkristallinen Feststoff.

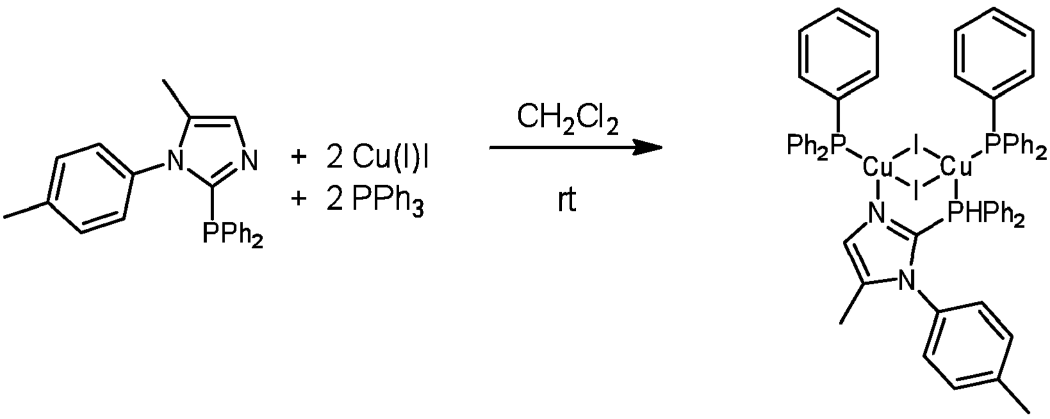


Charakterisierung:

Elementaranalyse:

gef.: C 55.58; H 4.05; N 1.74
(mit 1/4 Molekül DCM)
ges.: C 55.46; H 4.05; N 2.18

Das Emissionsspektrum ist in Fig. 22 gezeigt.

## XXIII. P∩N* = $Ph_2P$(iBuBenzimid), L = $PPh_3$: $Cu_2I_2(Ph_2P(iBuBenzimid)(PPh_3)_2$ (23)

Bei der Verbindung 23 handelt es sich um einen weißen, feinkristallinen Feststoff.

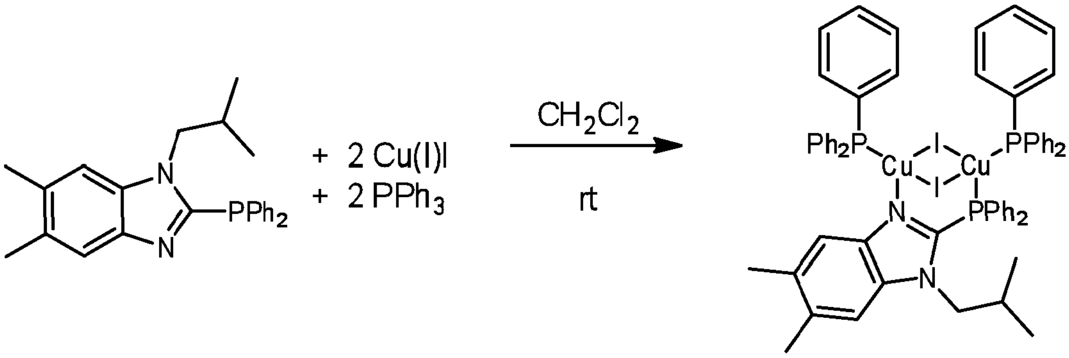


Charakterisierung:

Elementaranalyse:

gef.: C 56.20; H 4.55; N 1.69
(mit 1/4 Molekül DCM)
ges.: C 56.02; H 4.41; N 2.13

Das Emissionsspektrum ist in Fig. 23 gezeigt.

## XXIV. P∩N* = $Ph_2P$(OctBenzimid), L = $PPh_3$: $Cu_2I_2(Ph_2P(OctBenzimid)(PPh_3)_2$ (24)

Bei der Verbindung 24 handelt es sich um einen weißen, feinkristallinen Feststoff.

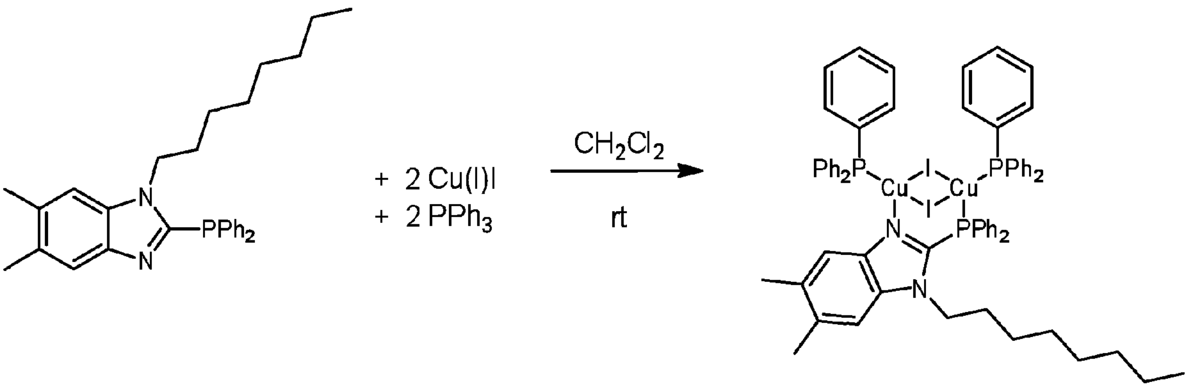


Charakterisierung:

Elementaranalyse:

gef.: C 57.60; H 4.79; N 1.93
ges.: C 57.91; H 4.86; N 2.08

Das Emissionsspektrum ist in Fig. 24 gezeigt.

## XXV. P∩N* = $Ph_2P$(PhenanthroImid), L = $PPh_3$: $Cu_2I_2(Ph_2P(PhenanthroImid)(PPh_3)_2$ (25)

Bei der Verbindung 25 handelt es sich um einen weißen, feinkristallinen Feststoff.

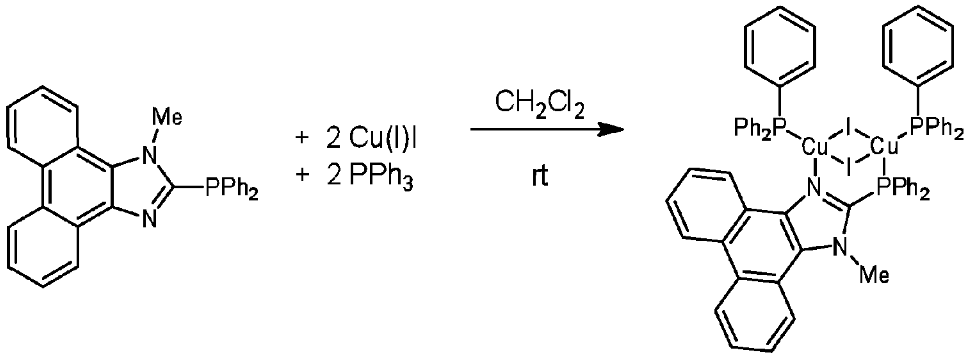


Charakterisierung:

Elementaranalyse:

gef.: C 57.66; H 3.88; N 1.91
(mit 1/8 Molekül DCM)
ges.: C 57.45; H 3.86; N 2.09

## XXVI. P∩N* = $Ph_2P(Ph_2Triaz)$, L = $PPh_3$: $Cu_2I_2(Ph_2P(Ph_2Triaz)(PPh_3)_2$ (26)

Bei der Verbindung **26** handelt es sich um einen weißen, feinkristallinen Feststoff.

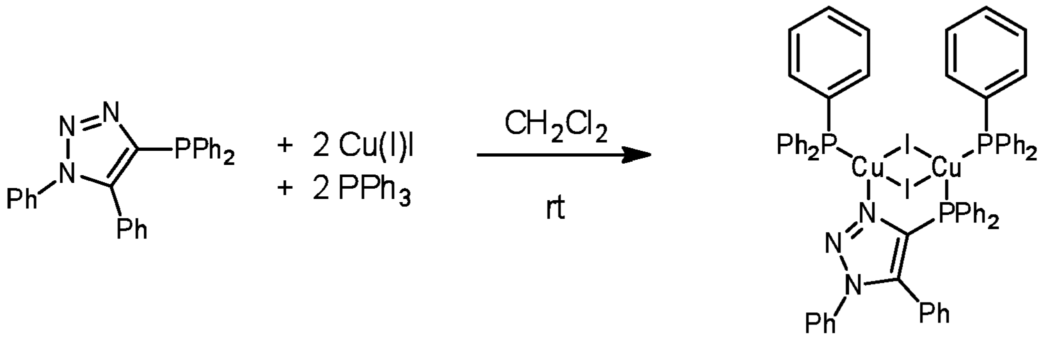


Charakterisierung:

Das Emissionsspektrum ist in Fig. 25 gezeigt.

**Referenzen**

[i] C. Adachi, M. A. Baldo, S. R. Forrest, S. Lamansky, M. E. Thompson, R. C. Kwong, Appl. Phys. Lett. 2001, 78, 1622.
[ii] X. H. Yang, D. C. Müller, D. Neher, K. Meerholz, Adv. Mater. 2006, 18, 948; X. H. Yang, D. Neher, Appl. Phys.

Lett. 2004, 84, 2476.
[iii] J. Shinar (Hrsg.), Organic light-emitting devices - A survey, AIP-Press, Springer, New York, 2004.
[iv] H. Yersin, Top. Curr. Chem. 2004, 241, 1.
[v] H. Yersin, Highly Efficient OLEDs with Phosphorescent Materials, Wiley-VCH, Weinheim 2008.
[vi] Z. H. Kafafi, Organic Electroluminescence, Taylor & Francis, Boca Raton, 2005.
[vii] M. E. Thompson, P. I. Djurovich, J. Li (University of Southern California, Los Angeles, CA), WO 2004/017043 A2, 2004.
[viii] M. E. Thompson, P. I. Djurovich, R. Kwong (University of Southern California, Los Angeles, CA, Universal Display Corp, Ewing, NY), WO 2004/016711 A1, 2004.
[ix] A. Tsuboyama, S. Okada, T. Takiguchi, K. Ueno, S. Igawa, J. Kamatani, M. Furugori, H. Iwawaki (Canon KK, Tokyo), WO 03/095587 A1, 2003.
[x] C.-M. Che, US 2003/0205707 A1, 2003.
[xi] C.-M. Che, W. Lu, M. C.-W. Chan, US 2002/0179885 A1, 2002.
[xii] J. Kamatani, S. Okada, A. Tsuboyama, T. Takiguchi, S. Igawa, US 2003/186080 A1, 2003.
[xiii]P. Stößel, I. Bach, A. Büsing (Covion Organic Semiconductors GmbH), DE 10350606 A1, 2005.
[xiv] M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005.
[xv] C. Lennartz, A. Vogler, V. Pawlowski (BASF AG), DE 10358665 A1, 2005.
[xvi] B. Hsieh, T. P. S. Thoms, J. P. Chen (Canon KK, Tokyo), US 2006/989273 B2, 2006.
[xvii]N. Schulte, S. Heun, I. Bach, P. Stoessel, K. Treacher (Covion Organic Semiconductors), WO 2006/003000 A1, 2006.
[xviii] A. Vogler, V. Pawlowski, H.-W. Schmidt, M. Thelakkat (BASF AG), WO 2006/032449 A1, 2006.
[xix] T. K. Hatwar, J. P. Spindler, R. H. Young (Eastman Kodak Co), WO 2006/028546 A1, 2006.
[xx] P. C. Ford, E. Cariati, J. Bourassa, Chem. Rev. 1999, 99, 3625.
[xxi] H. Araki, K. Tsuge, Y. Sasaki, S. Ishizaka, N. Kitamura, Inorg. Chem. 2007, 46, 10032.
[xxii] A. Rössler, G. Skillas, S. E. Pratsinis, Chemie in unserer Zeit 2001, 35, 32.
[xxiii] Y. Sun, K. Ye, H. Zhang, J. Zhang, L. Zhao, B. Li, G. Yang, B. Yang, Y. Wang, S.-W. Lai, C.-M. Che, Angew. Chem. 2006, 118, 5738.
[xxiv] Y. Chen, J. F. Gerald, L. T. Chadderton, L. Chaffron, Appl. Phys. Lett. 1999, 74, 2782.

## Patentansprüche

**1.** Kupfer(I)komplex aufweisend eine Struktur der Formel A

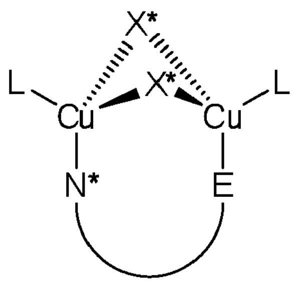

**Formel A**

mit
X* = Cl, Br, I, CN, OCN, SCN, Alkinyl und/oder $N_3$ (unabhängig voneinander),
N*∩E = ein zweibindiger Ligand mit
E = Phosphanyl/Arsenyl/Antimonyl-Rest der Form $R_2E$ (mit R = Alkyl, Aryl, Alkoxyl, Phenoxyl, oder Amid);
N* = Imin-Funktion, die Bestandteil einer aromatische Gruppe ist, die bevorzugt ausgewählt ist aus Pyridyl, Pyrimidyl, Pyridazinyl, Triazinyl, Oxazolyl, Thiazolyl, Imidazolyl, Pyrazol, Isoxazol, Isothiazol, 1,2,4-Triazole, 1,2,4-Oxadiazole, 1,2,4-Thiadiazole, Tetrazole, 1,2,3,4-Oxatriazole und/oder 1,2,3,4-Thiatriazole;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet;
L = entweder ein einzähniger Liganden $DR_3$ mit
D = Phosphanyl/Arsenyl/Antimonyl-Rest der Form $R_3D$ (mit R = Alkyl, Aryl, Alkoxyl, Phenoxyl, oder Amid), oder ein zweizähniger Liganden $R_2D$-B-$DR_2$ mit
D = Phosphanyl/Arsenyl/Antimonyl-Rest der Form $R_2D$ (mit R = Alkyl, Aryl, Alkoxyl, Phenoxyl, oder Amid), der über eine Brücke B mit einem weiteren Rest D verbunden ist, wobei die Brücke B eine Alkylen- oder Arylen-Gruppe oder eine Kombination beider, oder -O-, -NR- oder -$SiR_2$- ist;
wobei optional N*∩E und/oder L mindestens einen Substituenten zur Verbesserung des Ladungsträgertransports und/oder zur Erhöhung der Löslichkeit des Kupfer(I)komplexes in einem organischen Lösungsmittel aufweist.

**2.** Kupfer(I)komplex nach Anspruch 1, wobei N*∩E ausgewählt ist aus der Gruppe bestehend aus

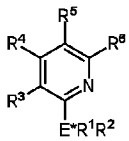 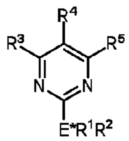 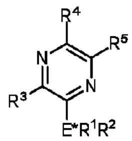 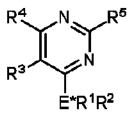 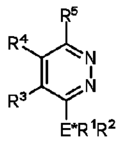 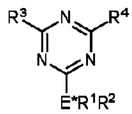

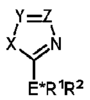

X = $NR^3$, Y = $CR^4$, Z = $CR^5$: 2E*$R^1R^2$-1$R^3$-4$R^5$-5$R^4$-1*H*-Imidazol
X = $NR^3$, Y = N, Z = $CR^4$: 5E*$R^1R^2$-1$R^3$-3$R^4$-1*H*-1,2,4-Triazol
X = $NR^3$, Y = $CR^4$, Z = N: 3E*$R^1R^2$-4$R^3$-5$R^4$-4*H*-1,2,4-Triazol
X = $NR^3$, Y = N, Z = N: 5E*$R^1R^2$-1$R^3$-1*H*-Tetrazol
X = O, Y = $CR^3$, Z = $CR^4$: 2E*$R^1R^2$-4$R^4$-5$R^3$-Oxazol
X = O, Y = N, Z = $CR^3$: 5E*$R^1R^2$-3$R^3$-1,2,4-Oxadiazol
X = O, Y = $CR^3$, Z = N: 2E*$R^1R^2$-5$R^3$-1,3,4-Oxadiazol
X = O, Y = N, Z = N: 5E*$R^1R^2$-1,2,3,4-Oxatriazol
X = S, Y = $CR^3$, Z = $CR^4$: 2E*$R^1R^2$-4$R^4$-5$R^3$-Thiazol
X = S, Y = N, Z = $CR^3$: 5E*$R^1R^2$-3$R^3$-1,2,4-Thiadiazol
X = S, Y = $CR^3$, Z = N: 2E*$R^1R^2$-5$R^3$-1,3,4-Thiadiazol
X = S, Y = N, Z = N: 5E*$R^1R^2$-1,2,3,4-Thiatriazol

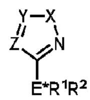

X = $NR^3$, Y = $CR^4$, Z = $CR^5$: 3E*$R^1R^2$-1$R^3$-4$R^5$-5$R^4$-1*H*-Pyrazol
X = $NR^3$, Y = N, Z = $CR^4$: 4E*$R^1R^2$-2$R^3$-5$R^4$-2*H*-1,2,3-Triazol
X = $NR^3$, Y = $CR^4$, Z = N: 3E*$R^1R^2$-1$R^3$-5$R^4$-1*H*-1,2,4-Triazol
X = $NR^3$, Y = N, Z = N: 5E*$R^1R^2$-2$R^3$-2*H*-Tetrazol
X = O, Y = $CR^3$, Z = $CR^4$: 3E*$R^1R^2$-4$R^4$-5$R^3$-Isoxazol
X = O, Y = N, Z = $CR^3$: 3E*$R^1R^2$-4$R^3$-1,2,5-Oxadiazol
X = O, Y = $CR^3$, Z = N: 3E*$R^1R^2$-5$R^3$-1,2,4-Oxadiazol
X = O, Y = N, Z = N: 4E*$R^1R^2$-1,2,3,5-Oxatriazol
X = S, Y = $CR^3$, Z = $CR^4$: 3E*$R^1R^2$-4$R^4$-5$R^3$-Isothiazol
X = S, Y = N, Z = $CR^3$: 3E*$R^1R^2$-4$R^3$-1,2,5-Thiadiazol
X = S, Y = $CR^3$, Z = N: 3E*$R^1R^2$-5$R^3$-1,2,4-Thiadiazol
X = S, Y = N, Z = N: 4E*$R^1R^2$-1,2,3,5-Thiatriazol

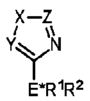

X = $NR^3$, Y = $CR^4$, Z = $CR^5$: 4E*$R^1R^2$-1$R^3$-2$R^5$-5$R^4$-1*H*-Imidazol
X = $NR^3$, Y = N, Z = $CR^4$: 3E*$R^1R^2$-1$R^3$-5$R^4$-1*H*-1,2,4-Triazol
X = $NR^3$, Y = $CR^4$, Z = N: 4E*$R^1R^2$-1$R^3$-5$R^4$-1*H*-1,2,3-Triazol
X = $NR^3$, Y = N, Z = N: 5E*$R^1R^2$-2$R^3$-2*H*-Tetrazol
X = O, Y = $CR^3$, Z = $CR^4$: 4E*$R^1R^2$-2$R^4$-5$R^3$-Oxazol
X = O, Y = N, Z = $CR^3$: 3E*$R^1R^2$-5$R^3$-1,2,4-Oxadiazol
X = O, Y = $CR^3$, Z = N: 4E*$R^1R^2$-5$R^3$-1,2,3-Oxadiazol
X = O, Y = N, Z = N: 4E*$R^1R^2$-1,2,3,5-Oxatriazol
X = S, Y = $CR^3$, Z = $CR^4$: 4E*$R^1R^2$-2$R^4$-5$R^3$-Thiazol
X = S, Y = N, Z = $CR^3$: 3E*$R^1R^2$-5$R^3$-1,2,4-Thiadiazol
X = S, Y = $CR^3$, Z = N: 4E*$R^1R^2$-5$R^3$-1,2,3-Thiadiazol
X = S, Y = N, Z = N: 4E*$R^1R^2$-1,2,3,5-Thiatriazol

mit
E* = P, As oder Sb
X = $NR^3$, O oder S
Y = $CR^3$, $CR^4$ oder N Z = $CR^4$, $CR^5$ oder N
$R^1$-$R^5$ sind jeweils unabhängig voneinander Wasserstoff, Halogen oder Substituenten, die über Sauerstoff- (-OR), Stickstoff- (-$NR_2$) oder Siliziumatome (-$SiR_3$) gebunden sind sowie Alkyl- (auch verzweigt oder zyklisch), Aryl-, Heteroaryl-, Alkenyl-, Alkinyl-Gruppen oder substituierte Alkyl-(auch verzweigt oder zyklisch), Aryl-, Heteroaryl- und

Alkenyl-Gruppen mit Substituenten wie Halogene oder Deuterium, Alkylgruppen (auch verzweigt oder zyklisch), und weitere Donor- und Akzeptor-Gruppen, wie beispielsweise Amine, Carboxylate und deren Ester, und $CF_3$-Gruppen; R3-R5 führen optional zu annelierten Ringsystemen;
und Ligand L aufweist oder besteht aus:

entweder zwei einzähnigen Liganden $DR_3$ mit
D = P, As oder Sb
R in $DR_3$ ist jeweils unabhängig voneinander Wasserstoff, Halogen oder Substituenten, die über Sauerstoff- (-OR), Stickstoff- (-$NR_2$) oder Siliziumatome (-$SiR_3$) gebunden sind sowie Alkyl- (auch verzweigt oder zyklisch), Aryl-, Heteroaryl-, Alkenyl-, Alkinyl-Gruppen oder substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere Donor- und
Akzeptor-Gruppen, wie beispielsweise Amine, Carboxylate und deren Ester, und $CF_3$-Gruppen; die drei einzelnen Reste R führen optional zu annelierten Ringsystemen;

oder einem zweizähnigen Liganden $R_2D$-B-$DR_2$ mit:

D = P, As oder Sb
R in $R_2D$ ist jeweils unabhängig voneinander Wasserstoff, Halogen oder Substituenten, die über Sauerstoff- (-OR), Stickstoff- (-$NR_2$) oder Siliziumatome (-$SiR_3$) gebunden sind sowie Alkyl- (auch verzweigt oder zyklisch), Aryl-, Heteroaryl-, Alkenyl-, Alkinyl-Gruppen oder substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere Donor- und Akzeptor-Gruppen, wie beispielsweise Amine, Carboxylate und deren Ester, und $CF_3$-Gruppen, die über eine Brücke B mit einem weiteren Rest D verbunden ist und damit einen zweizähnigen Liganden bildet, wobei die Brücke B eine Alkylen- oder Arylen-Gruppe oder eine Kombination beider, oder -O-, -NR- oder -$SiR_2$- ist; die Reste $R_2$ führen optional zu anellierten Ringsystemen; wobei $R_2D$-B-$DR_2$ bevorzugt ausgewählt ist aus:

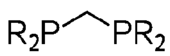 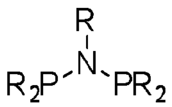 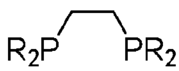 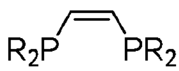 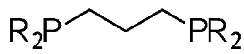

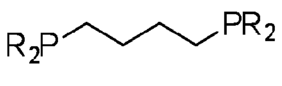 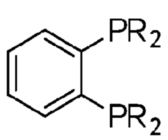 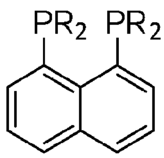 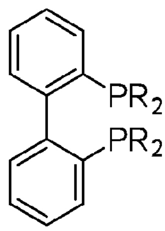 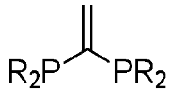

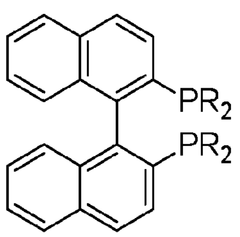 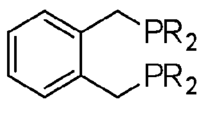 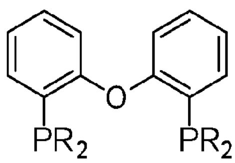 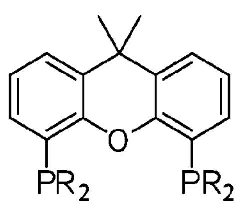

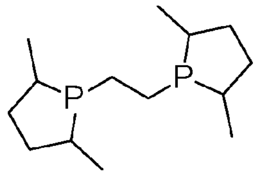
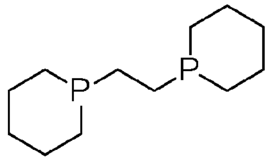
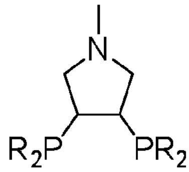
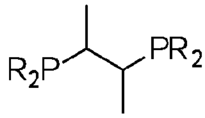

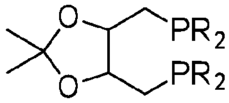
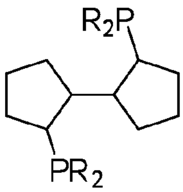
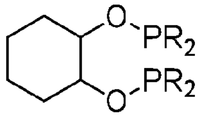
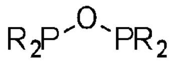
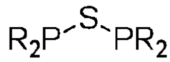

**3.** Kupfer(I)komplex nach Anspruch 1 oder 2, wobei der Substituent zur Erhöhung der Löslichkeit ausgewählt ist aus der Gruppe bestehend aus:

- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30, verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

**4.** Kupfer(I)komplex nach Anspruch 1 oder 2, wobei der Substituent zur Verbesserung des Ladungsträgertransports ausgewählt ist aus der Gruppe bestehend aus Elektronenleiter und Lochleiter.

**5.** Verfahren zur Herstellung eines Kupfer(I)komplexes nach Anspruch 1 bis 4, aufweisend den Schritt:

Durchführen einer Reaktion von N*∩E und L mit Cu(I)X,
wobei

X* = Cl, Br, I, CN, OCN, SCN, Alkinyl und/oder $N_3$ (unabhängig voneinander),
N*∩E = ein zweibindiger Ligand mit
E = Phosphanyl/Arsenyl/Antimonyl-Rest der Form $R_2E$ (mit R = Alkyl, Aryl, Alkoxyl, Phenoxyl, oder Amid);
N* = Imin-Funktion, die Bestandteil einer aromatische Gruppe ist, die bevorzugt ausgewählt ist aus Pyridyl, Pyrimidyl, Pyridazinyl, Triazinyl, Oxazolyl, Thiazolyl, Imidazolyl, Pyrazol, Isoxazol, Isothiazol, 1,2,4-Triazole, 1,2,4-Oxadiazole, 1,2,4-Thiadiazole, Tetrazole, 1,2,3,4-Oxatriazole und/oder 1,2,3,4-Thiatriazole;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet; und
L in Form entweder zweier einzähnigen Liganden $DR_3$ mit
D = Phosphanyl/Arsenyl/Antimonyl-Rest der Form $R_3D$ (mit R = Alkyl, Aryl, Alkoxyl, Phenoxyl, oder Amid) oder in Form eines zweizähnigen Liganden $R_2D$-B-$DR_2$ mit
D = Phosphanyl/Arsenyl/Antimonyl-Rest der Form $R_2D$ (mit R = Alkyl, Aryl, Alkoxyl, Phenoxyl, oder Amid), die über eine Brücke B mit einem weiteren Rest D verbunden ist, wobei die Brücke B eine Alkylen- oder Arylen-Gruppe oder eine Kombination beider, oder -O-, -NR- oder -$SiR_2$- ist.

**6.** Verfahren nach Anspruch 5, wobei die Reaktion in Dichlormethan durchgeführt wird.

**7.** Verfahren nach Anspruch 5 oder 6, weiterhin aufweisend den Schritt der Zugabe von Diethylether oder Pentan zur Gewinnung des Kupfer(I)komplexes in Form eines Feststoffs.

**8.** Verfahren nach Anspruch 5 bis 7, weiterhin aufweisend den Schritt der Substitution mindestens eines Liganden N*∩E und/oder mindestens eines Liganden L mit mindestens einem Substituenten zur Erhöhung der Löslichkeit, der ausgewählt sein kann aus der Gruppe bestehend aus:

- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

**9.** Verfahren nach Anspruch 5 bis 8, weiterhin aufweisend den Schritt der Substitution mindestens eines Liganden N*∩E und/oder L mit mindestens einer funktionellen Gruppe zur Verbesserung des Ladungsträgertransports, die ausgewählt ist aus Elektronenleiter und Lochleiter.

**10.** Verwendung eines Kupfer(I)komplexes nach Anspruch 1 bis 4 als Emitter oder Absorber in einem optoelektronischen Bauelement.

**11.** Verwendung nach Anspruch 10, wobei das optoelektronische Bauelement ausgewählt ist aus der Gruppe bestehend aus:

- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas-und Dampf Sensoren,
- organischen Solarzellen,
- Organischen Feldeffekttransistoren,
- Organischen Lasern und
- Down-Konversions-Elementen.

**12.** Verwendung nach Anspruch 10 oder 11, **dadurch gekennzeichnet, dass** der Anteil des Kupfer(I)komplexes am Emitter oder Absorber 100 % beträgt.

**13.** Verwendung nach Anspruch 10 oder 11, **dadurch gekennzeichnet, dass** der Anteil des Kupfer(I)komplexes am Emitter oder Absorber 1 % bis 99 % beträgt.

**14.** Verwendung nach Anspruch 10 bis 13, **dadurch gekennzeichnet, dass** die Konzentration des Kupfer(I)komplexes als Emitter in optischen Licht emittierenden Bauelementen, insbesondere in OLEDs, zwischen 1 % und 10 % beträgt.

**15.** Optoelektronisches Bauelement, aufweisend einen Kupfer(I)komplex nach Anspruch 1 bis 4.

**16.** Optoelektronisches Bauelement nach Anspruch 15, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

**17.** Verfahren zur Herstellung eines optoelektronischen Bauelements, wobei ein Kupfer(I)komplex nach Anspruch 1 bis 4 verwendet wird.

**18.** Verfahren nach Anspruch 17, **gekennzeichnet durch** Aufbringen eines Kupfer(I)komplexes nach Anspruch 1 bis 4 auf einen Träger.

**19.** Verfahren nach Anspruch 18, **dadurch gekennzeichnet, dass** das Aufbringen nass-chemisch, mittels kolloidaler Suspension oder mittels Sublimation erfolgt.

**20.** Verfahren zur Veränderung der Emissions- und/oder Absorptionseigenschaften eines elektronischen Bauelements, **gekennzeichnet durch**
Einbringen eines Kupfer(I)komplexes nach Anspruch 1 bis 4 in ein Matrixmaterial zur Leitung von Elektronen oder Löchern in einem optoelektronischen Bauelement.

**21.** Verwendung eines Kupfer(I)komplexes nach Anspruch 1 bis 4, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Figur 1A

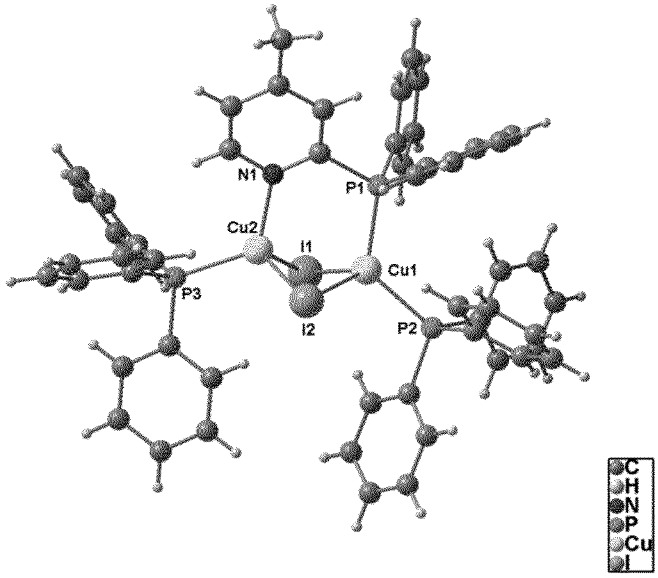

## Figur 1B

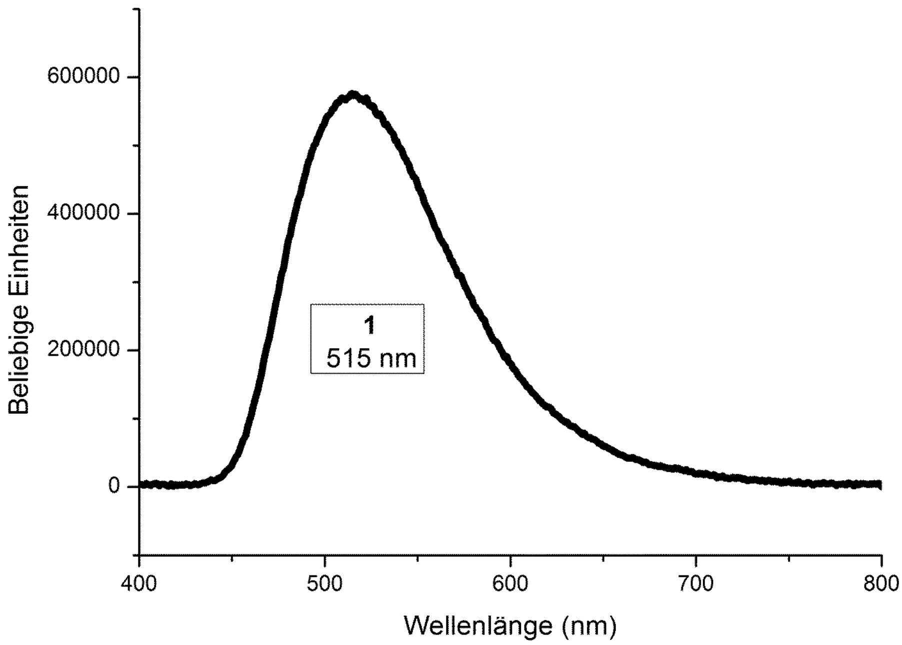

Figur 2

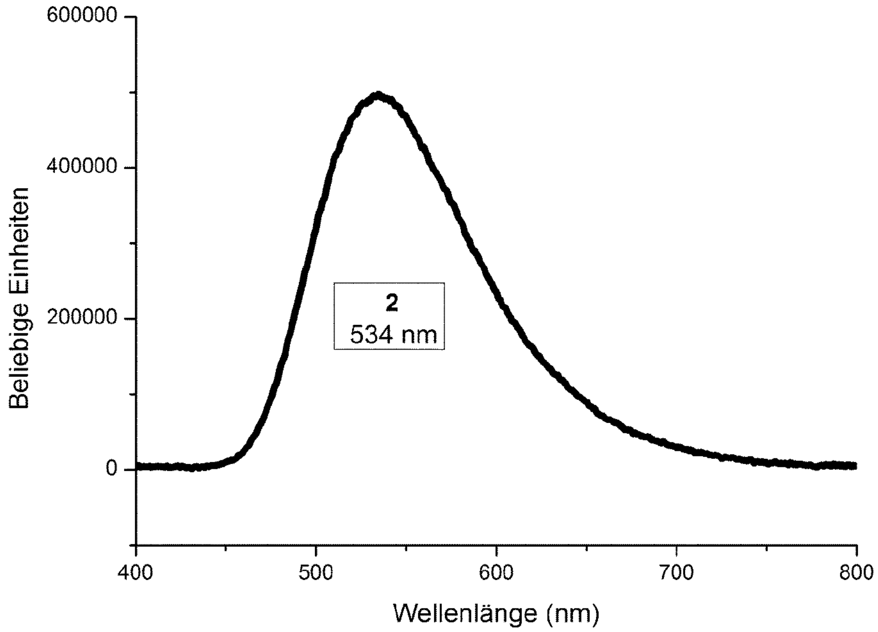


Figur 3

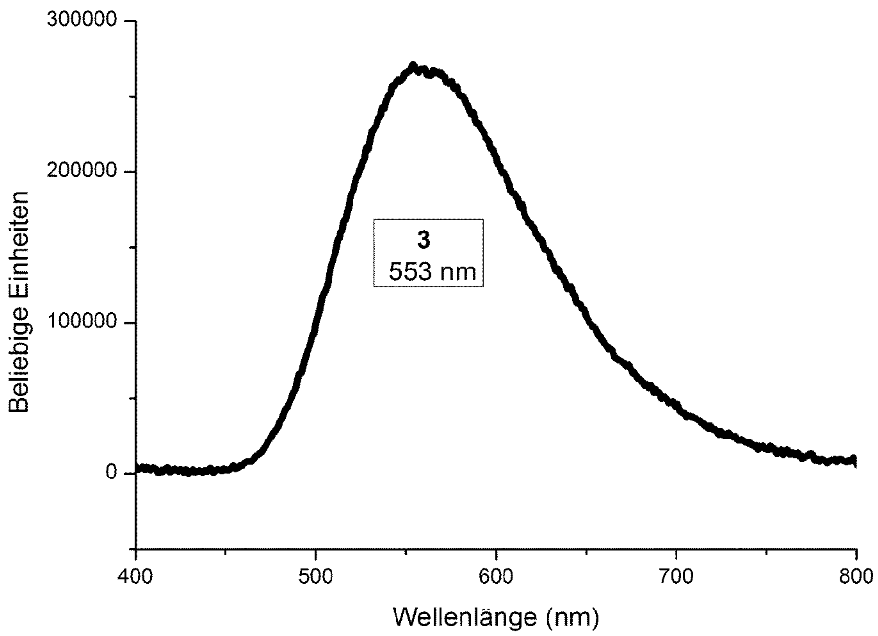

**Figur 4**

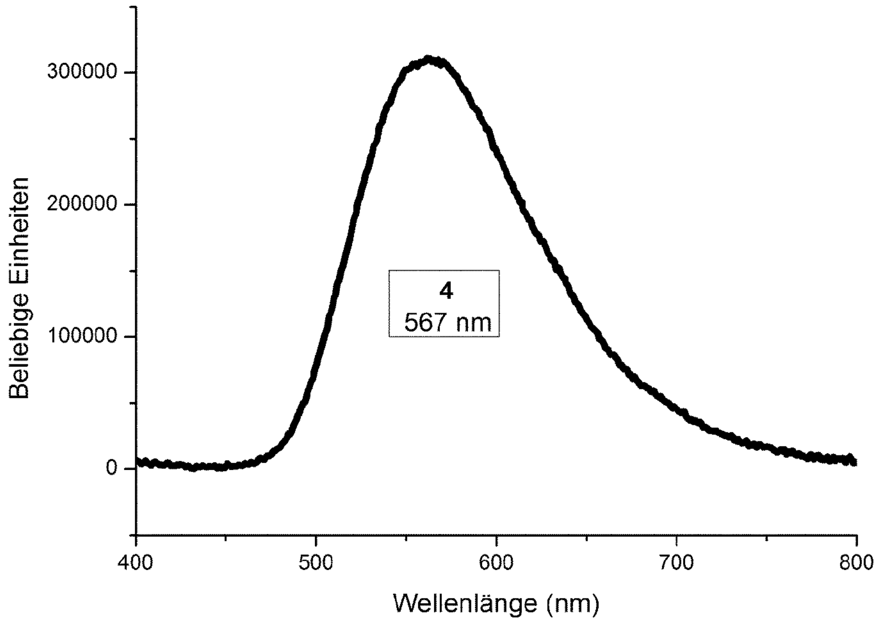


**Figur 5**

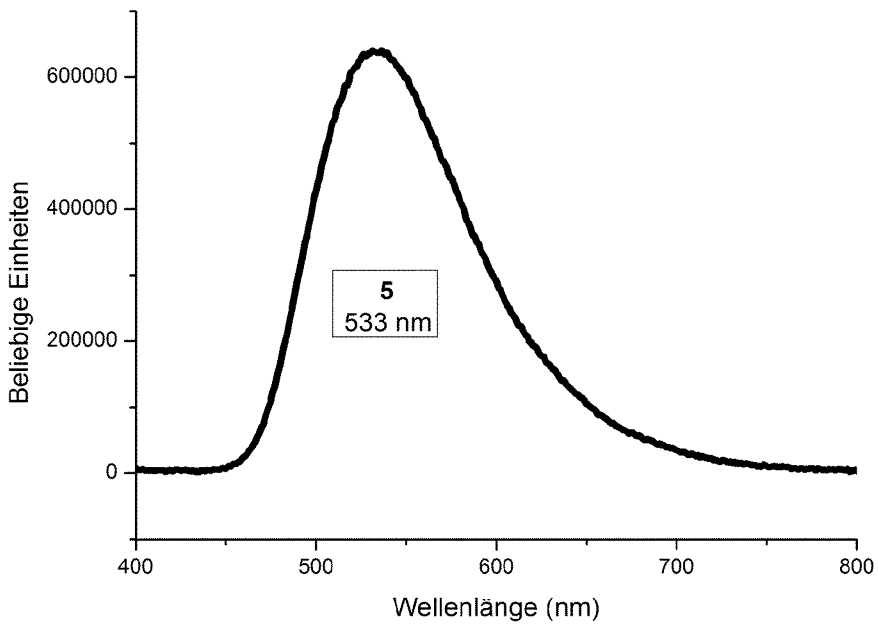

**Figur 6**

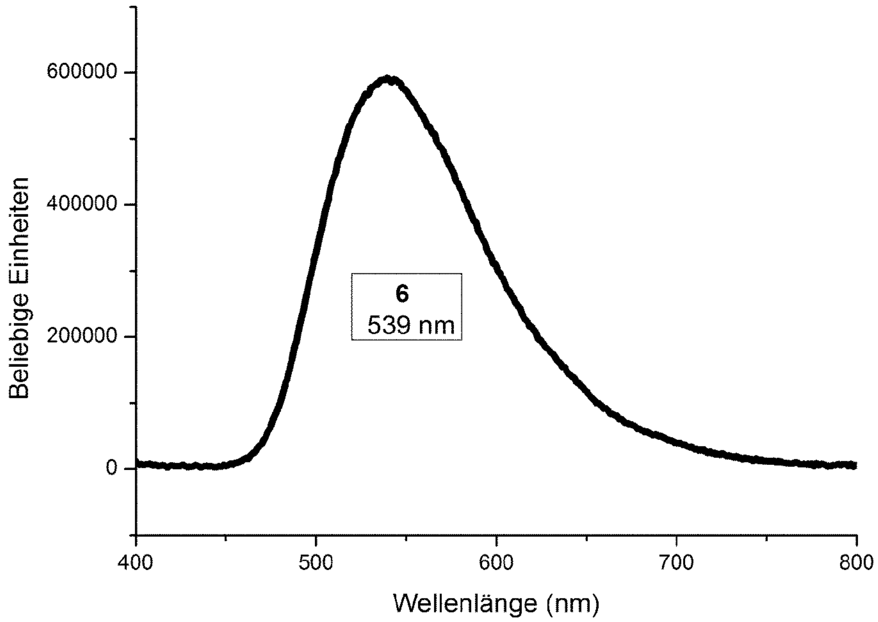


**Figur 7**

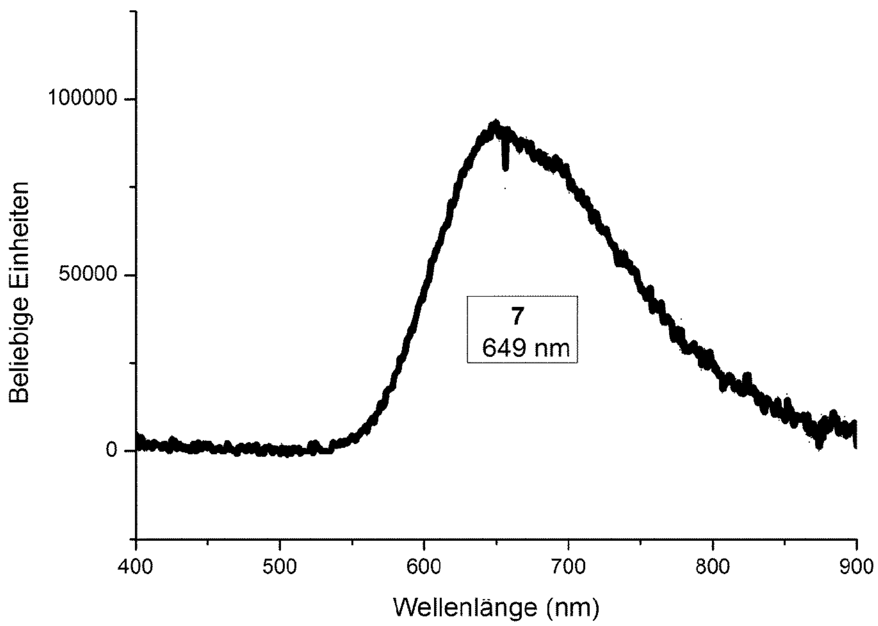

Figur 8

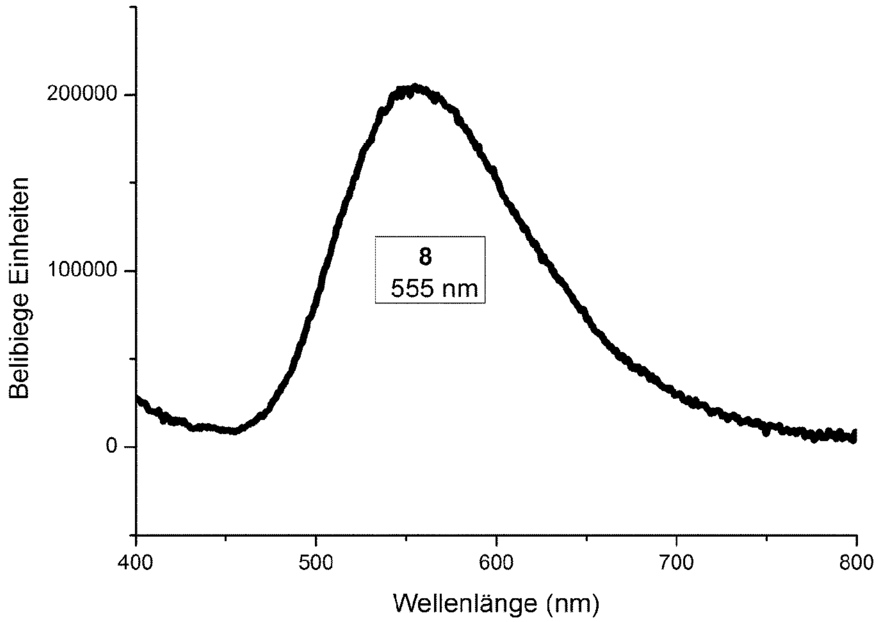


Figur 9

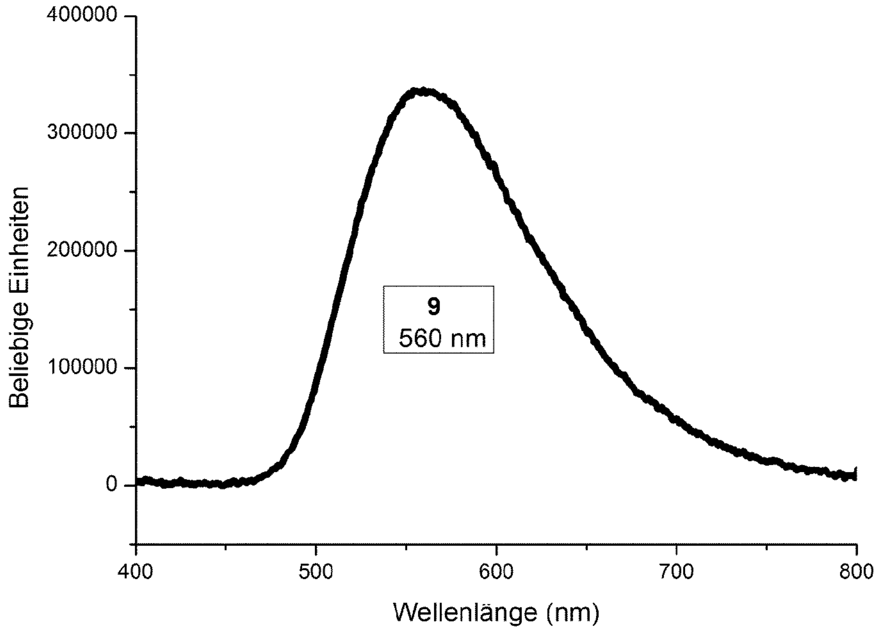

## Figur 10

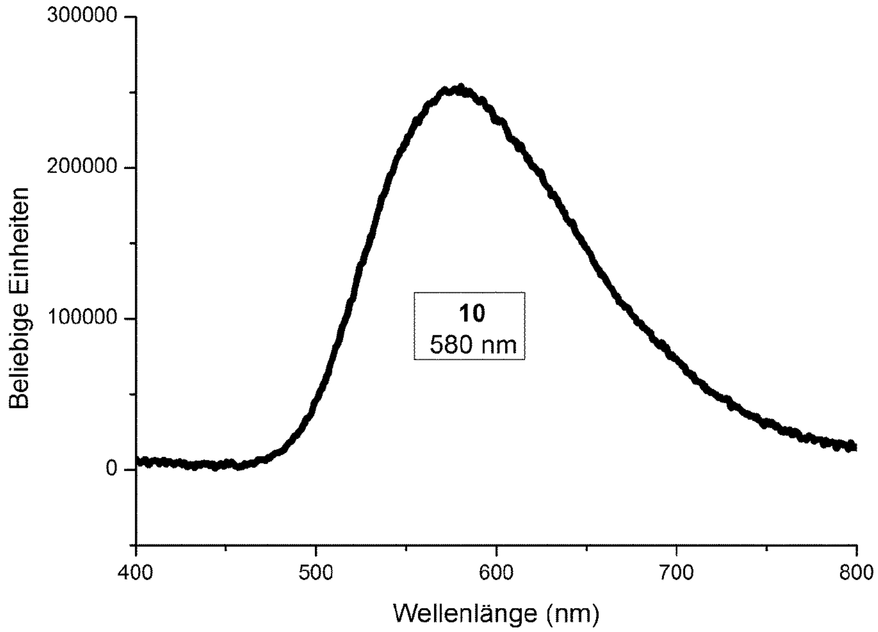


## Figur 11

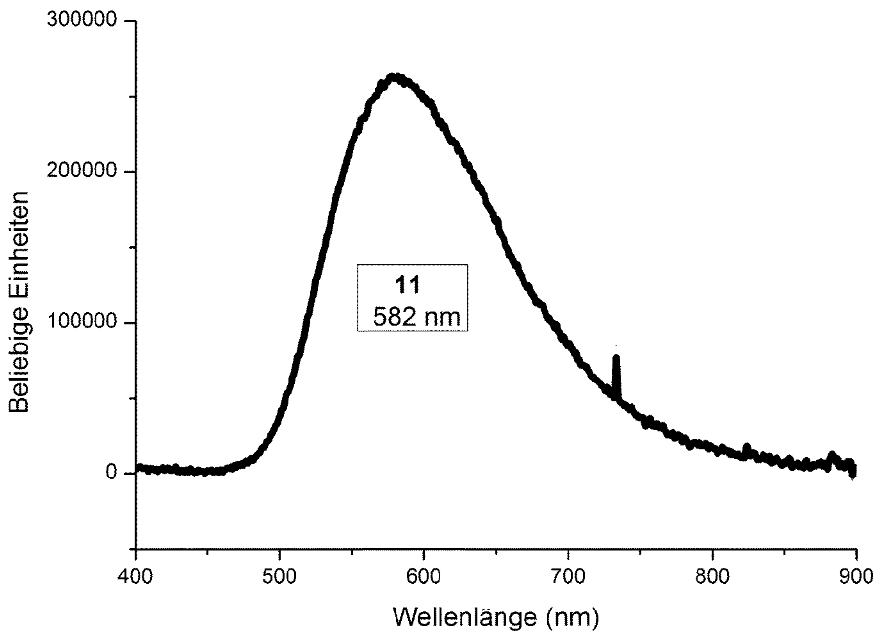

Figur 12

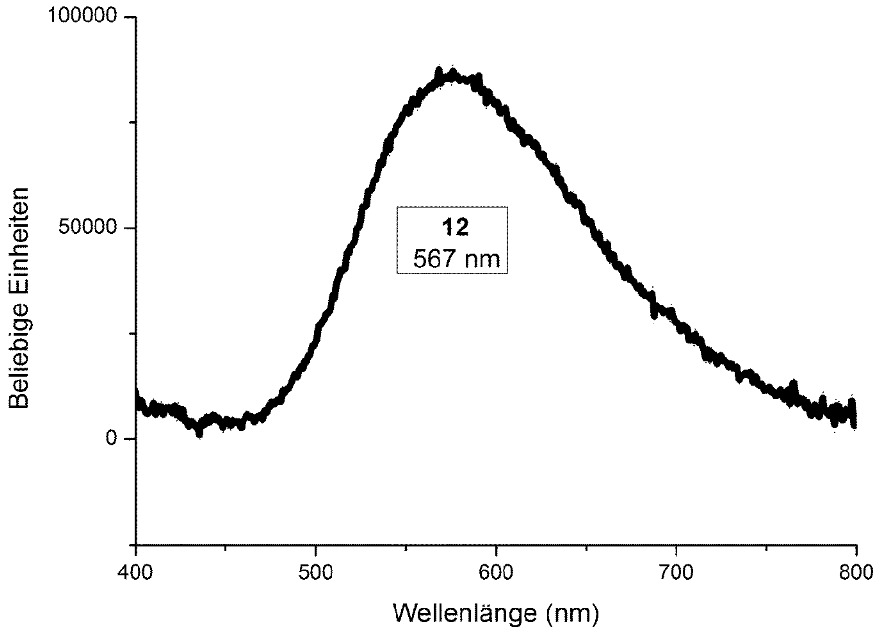


Figur 13

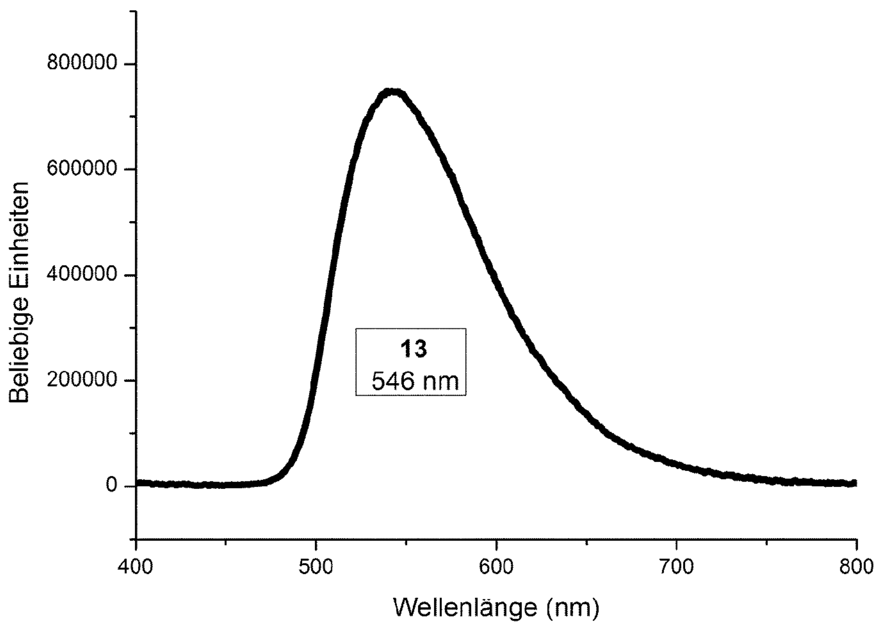

**Figure 14**

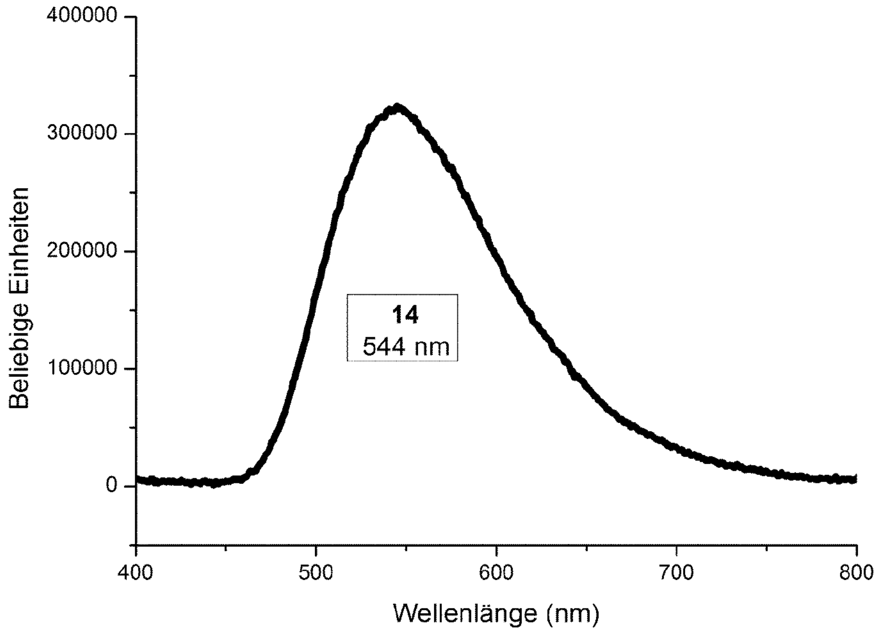


**Figur 15**

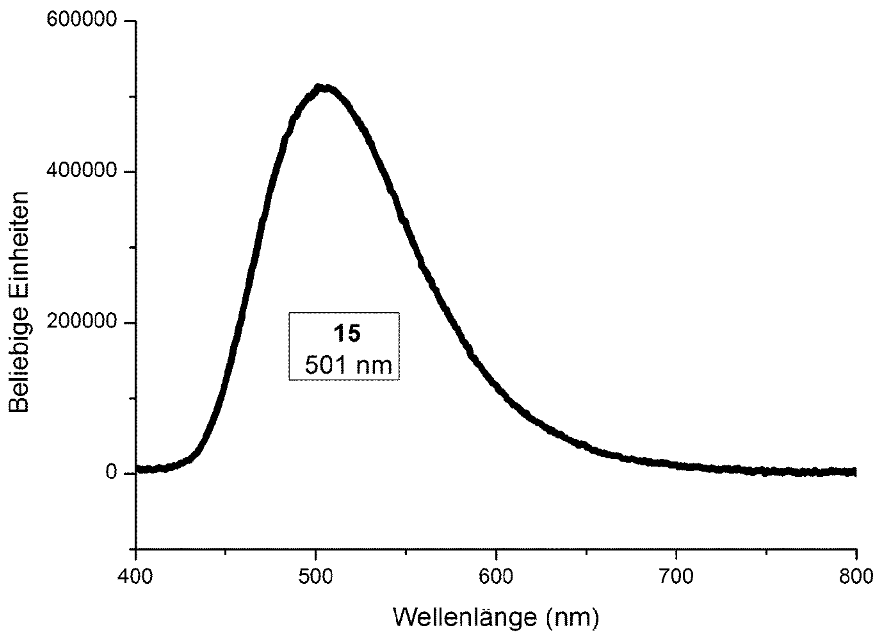

Figur 16

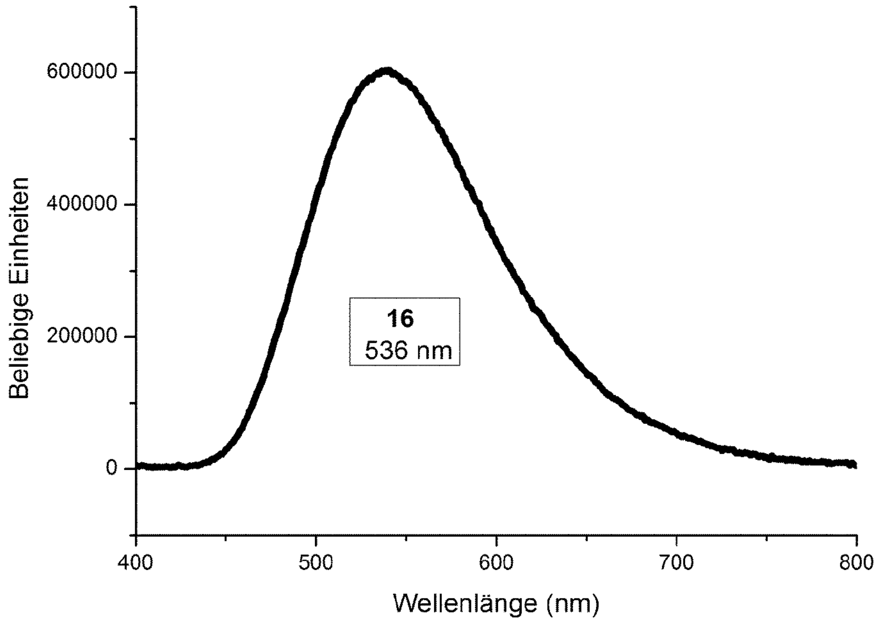


Figur 17

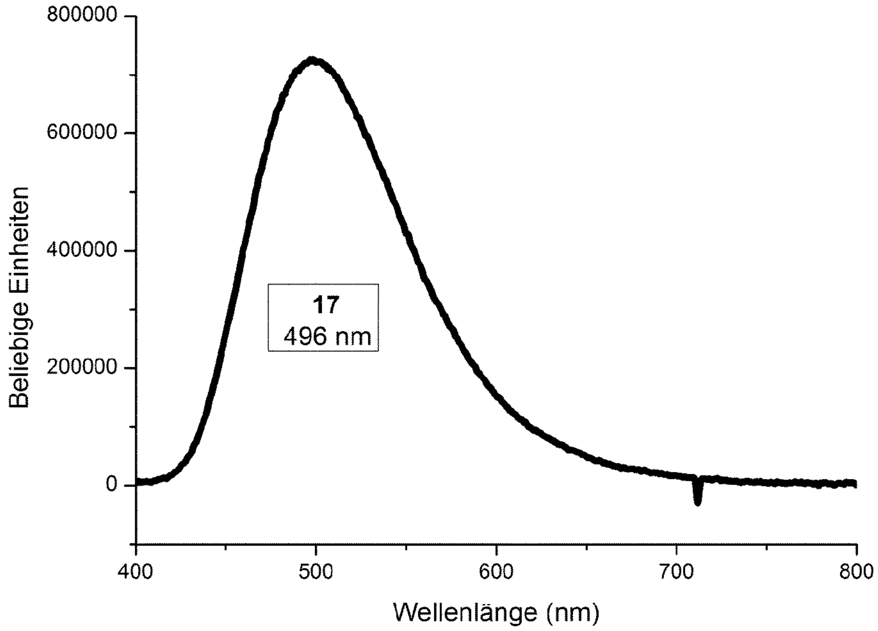

**Figur 18**

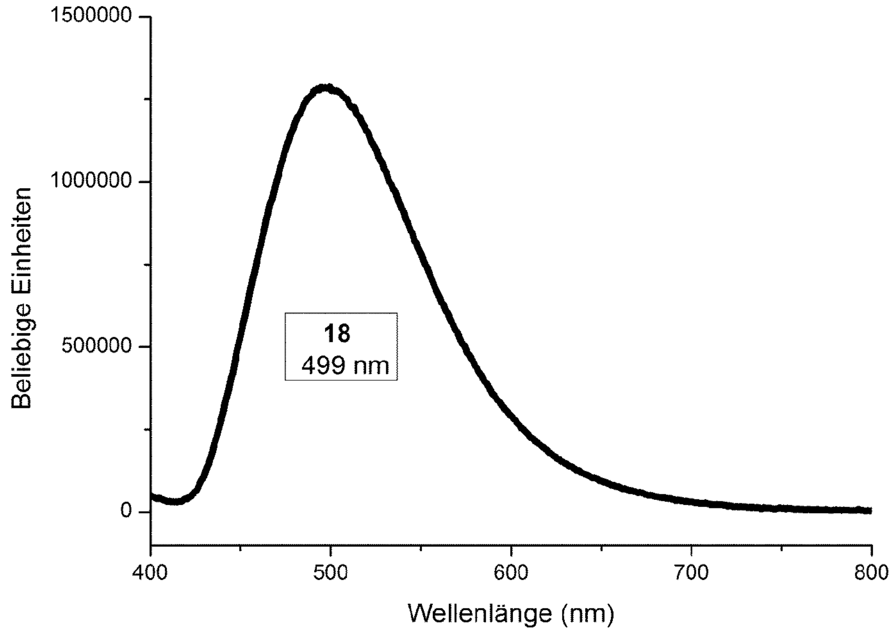


**Figure 19**

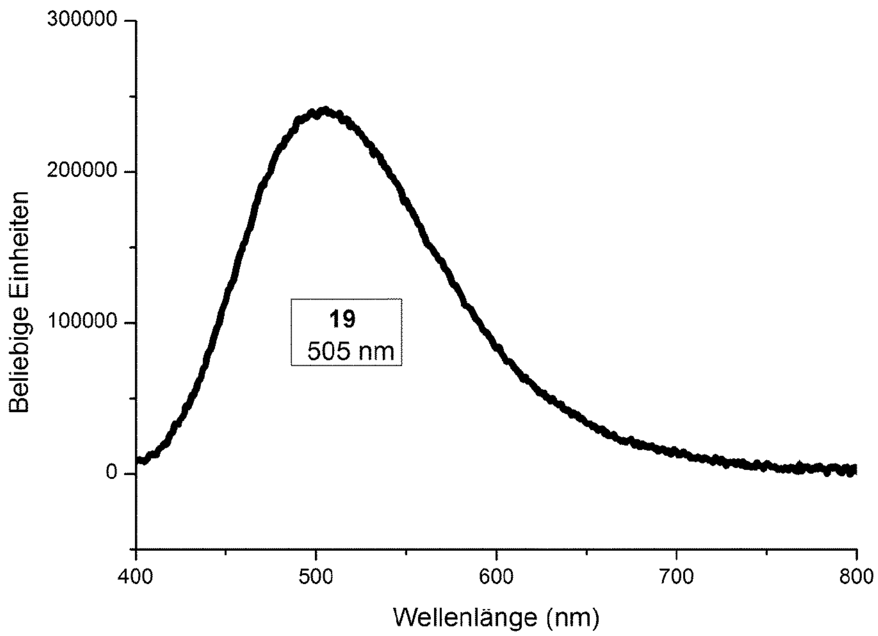

Figure 20

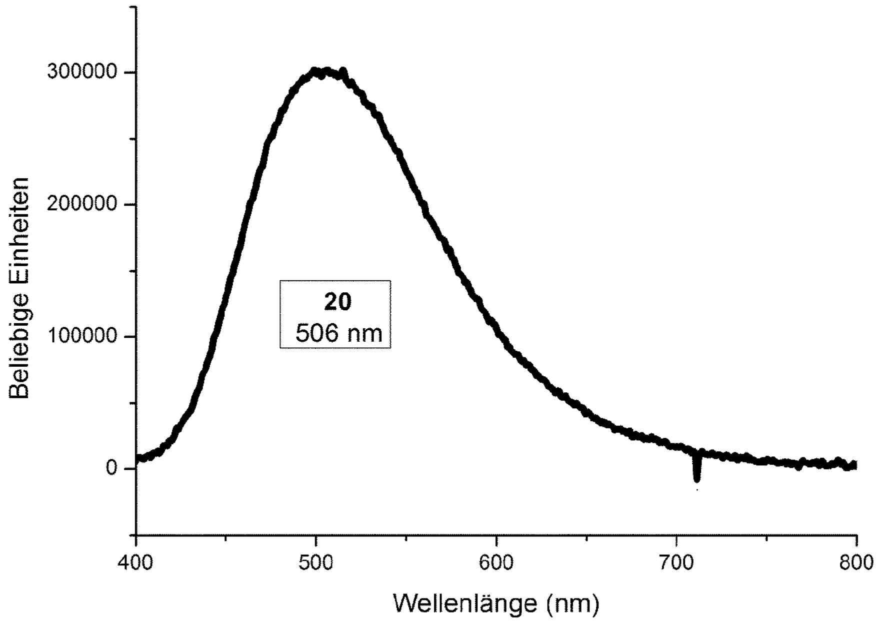


Figur 21

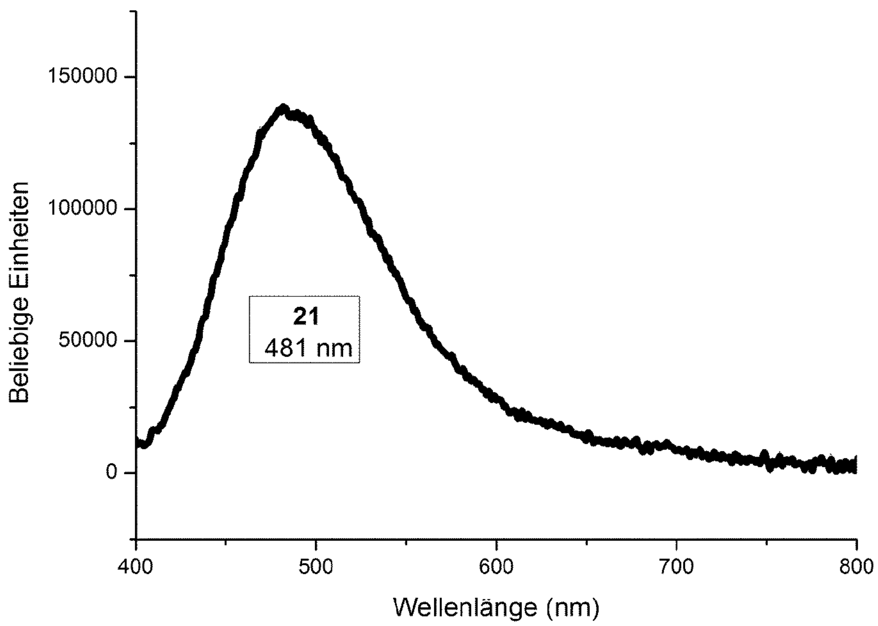

Figur 22

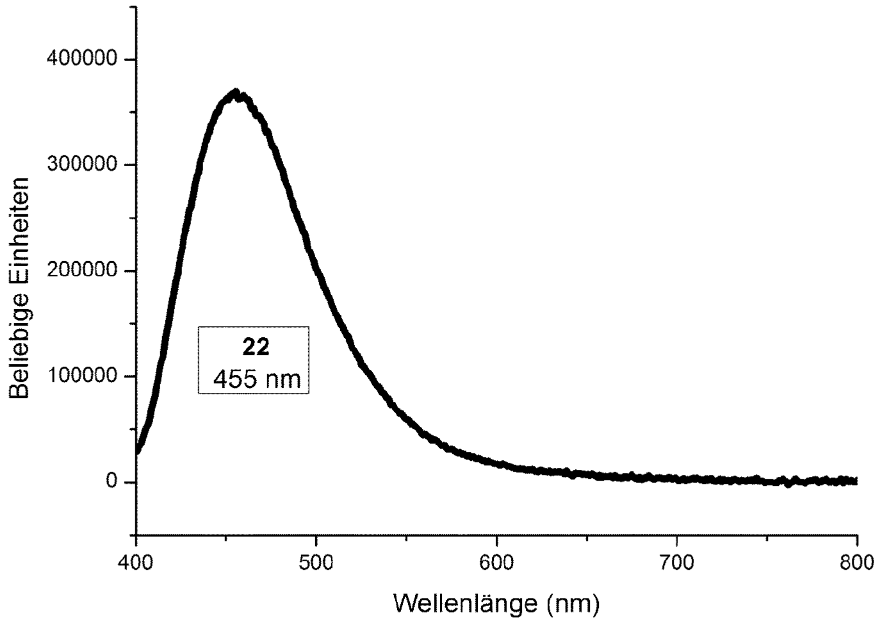


Figur 23

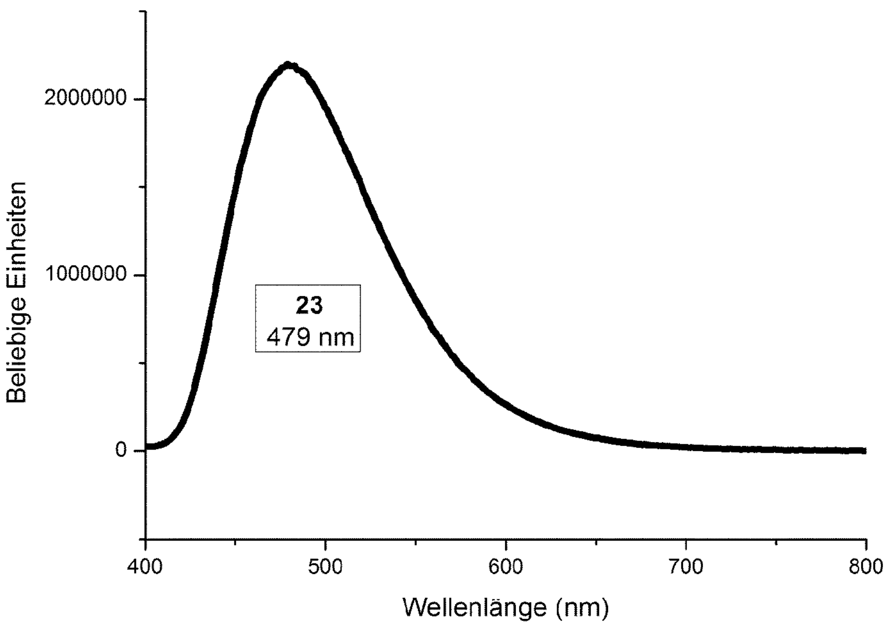

**Figur 24**

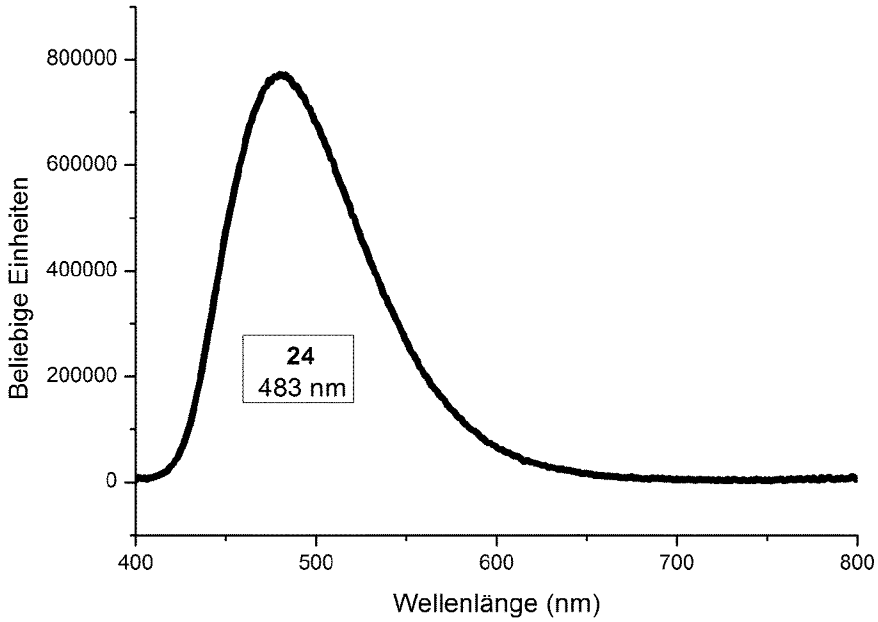


**Figur 25**

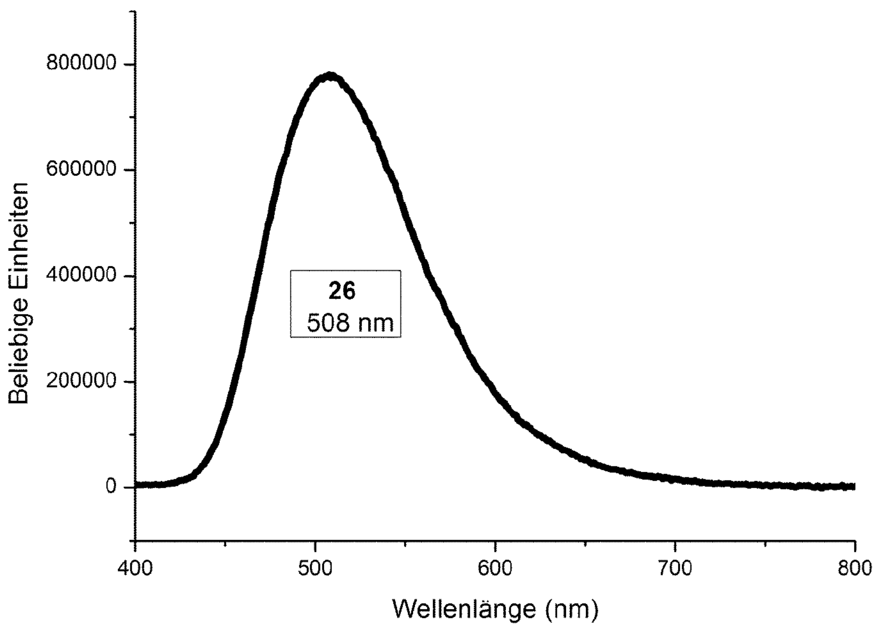

Europäisches Patentamt
European Patent Office
Office européen des brevets

# EUROPÄISCHER RECHERCHENBERICHT

Nummer der Anmeldung
EP 11 19 5010

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2010/149748 A1 (YERSIN HARTMUT [DE]; MONKOWIUS UWE [AT]; FISCHER TOBIAS [DE]; HOFBECK) 29. Dezember 2010 (2010-12-29)<br>* Anspruch 1 *<br>----- | 1-21 | INV.<br>C07F1/08<br>H01L51/00 |

RECHERCHIERTE SACHGEBIETE (IPC)
C07F
H01L

Der vorliegende Recherchenbericht wurde für alle Patentansprüche erstellt

1

| Recherchenort | Abschlußdatum der Recherche | Prüfer |
|---|---|---|
| München | 15. März 2012 | Bader, Karl Günther |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR. EP 11 19 5010

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-03-2012

| Im Recherchenbericht angeführtes Patentdokument | Datum der Veröffentlichung | Mitglied(er) der Patentfamilie | Datum der Veröffentlichung |
|---|---|---|---|
| WO 2010149748 A1 | 29-12-2010 | DE 102009030475 A1 | 05-01-2011 |
| | | EP 2408787 A1 | 25-01-2012 |
| | | WO 2010149748 A1 | 29-12-2010 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2004017043 A2
- WO 2004016711 A1
- WO 03095587 A1
- US 20030205707 A1, C.-M. Che
- US 20020179885 A1, C.-M. Che, W. Lu, M. C.-W. Chan
- US 2003186080 A1, J. Kamatani, S. Okada, A. Tsuboyama, T. Takiguchi, S. Igawa
- DE 10350606 A1
- DE 10338550 A1
- DE 10358665 A1
- US 2006989273 B2
- WO 2006003000 A1
- WO 2006032449 A1
- WO 2006028546 A1


### In der Beschreibung aufgeführte Nicht-Patentliteratur


- **C.-Y. CHEN ; M. WANG ; J.-Y. LI ; N. POOTRAKULCHOTE ; L. ALIBABAEI ; C.-H. NGOC-LE ; J.-D. DECOPPET ; J.-H. TSAI ; C. GRÄTZEL ; C.-G. WU.** *ACS Nano,* 2009, vol. 3, 3103
- **C. ADACHI, M. A. BALDO ; S. R. FORREST ; S. LAMANSKY ; M. E. THOMPSON ; R. C. KWONG.** *Appl. Phys. Lett.,* 2001, vol. 78, 1622
- **X. H. YANG ; D. C. MÜLLER ; D. NEHER ; K. MEERHOLZ.** *Adv. Mater.,* 2006, vol. 18, 948
- **X. H. YANG ; D. NEHER.** *Appl. Phys. Lett.,* 2004, vol. 84, 2476
- Organic light-emitting devices - A survey. Springer, 2004
- **H. YERSIN.** *Top. Curr. Chem.,* 2004, vol. 241, 1
- **YERSIN.** Highly Efficient OLEDs with Phosphorescent Materials. Wiley-VCH, 2008
- **Z. H. KAFAFI.** Organic Electroluminescence. Taylor & Francis, 2005
- **P. C. FORD ; E. CARIATI ; J. BOURASSA.** *Chem. Rev.,* 1999, vol. 99, 3625
- **H. ARAKI ; K. TSUGE ; Y. SASAKI ; S. ISHIZAKA ; N. KITAMURA.** *Inorg. Chem.,* 2007, vol. 46, 10032
- **A. RÖSSLER ; G. SKILLAS ; S. E. PRATSINIS.** *Chemie in unserer Zeit,* 2001, vol. 35, 32
- **Y. SUN ; K. YE ; H. ZHANG ; J. ZHANG ; L. ZHAO ; B. LI ; G. YANG ; B. YANG ; Y. WANG ; S.-W. LAI.** *Angew. Chem.,* 2006, vol. 118, 5738
- **Y. CHEN ; J. F. GERALD ; L. T. CHADDERTON ; L. CHAFFRON.** *Appl. Phys. Lett.,* 1999, vol. 74, 2782